# EUROPEAN PATENT SPECIFICATION

(11) **EP 4 060 740 B1**
(45) Date of publication and mention of the grant of the patent: **21.08.2024**
(21) Application number: 20887476.8
(22) Date of filing: 06.11.2020
(51) Int. Cl.: H01L 27/146

(54) **SOLID-STATE IMAGING ELEMENT AND METHOD FOR MANUFACTURING SAME**
FESTKÖRPERBILDGEBUNGSELEMENT UND VERFAHREN ZUR HERSTELLUNG DAVON
ÉLÉMENT D'IMAGERIE À SEMI-CONDUCTEUR ET SON PROCÉDÉ DE FABRICATION

(30) Priority: 13.11.2019 JP 2019205647
(43) Date of publication of application: 21.09.2022
(73) Proprietor: Sony Semiconductor Solutions Corporation, Atsugi-shi Kanagawa 243-0014 (JP)
(72) Inventor: FUKUI, Ryo, Atsugi-shi, Kanagawa 243-0014 (JP); MACHIDA, Takashi, Atsugi-shi, Kanagawa 243-0014 (JP); AKIYAMA, Kentaro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2020/041634
(87) International publication number: WO 2021/095668

(56) References cited:
- WO-A1-2013/065569
- WO-A1-2016/136486
- JP-A- 2015 046 477
- JP-A- 2018 148 039
- JP-A- H05 188 148
- US-A1- 2015 091 122

## Description

### [Technical Field]

The present disclosure relates to a solid-state imaging device and a method of producing the same.

### [Background Art]

A global shutter (GS) type solid-state imaging device includes a memory unit in addition to a photodiode and a floating diffusion unit for each pixel. For the GS type solid-state imaging device, in order to reduce an area of an integrated circuit, a laminated structure in which a memory unit is arranged in a longitudinal direction (vertical direction) instead of a lateral direction (horizontal direction) of the photodiode has been proposed.
PTL 3 discloses a technique that pertains to a solid-state imaging element, a method for manufacturing the solid-state imaging element, and an electronic device, such that the solid-state imaging element is provided with a global shutter function, and is capable of suppressing white spots and dark current. The present invention is provided with a semiconductor substrate, a photodiode formed on the semiconductor substrate, and a floating diffusion region where a signal charge that is accumulated on the photodiode is transferred. Further, a solid-state imaging element is configured provided with a shielding layer in the semiconductor substrate, the shielding layer comprising a level light-shielding part parallel with the semiconductor substrate surface covering the floating diffusion region, and a perpendicular shielding part that is perpendicular to the semiconductor substrate surface.
PTL 4 discloses a solid-state image pickup device that comprises: a semiconductor substrate having a light incident surface; a photoelectric conversion part provided in each pixel on the light incident surface side in the semiconductor substrate; a charge storage part provided in each pixel on the side opposite to the light incident surface from the photoelectric conversion part in the semiconductor substrate; a first transfer transistor that transmits a signal charge accumulated in the photoelectric conversion part to the charge storage part; an exhaust transistor that exhausts an unnecessary charge to an overflow drain; a wiring layer provided to a surface opposite to the light incident surface of the semiconductor substrate; a first vertical electrode and a second vertical electrode which extends in the photoelectric conversion part from the surface opposite to the light incident surface of the semiconductor substrate; a first shading film provided in a thickness direction of the semiconductor substrate in at least one part of the circumference of the photoelectric conversion part; and a second shading film provided in a surface deference of the semiconductor substrate between the photoelectric conversion part and the charge storage part.

### [Citation List]

### [Patent Literature]

[PTL 1]
   WO 2016/136486
[PTL 2]
   JP 2013-98446 A
[PTL 3]
   WO 2013/065569 A1
[PTL 4]
   JP 2018148039 A

### [Summary]

### [Technical Problem]

In a solid-state imaging device having a laminated structure, it is necessary to form a light-blocking unit extending in a lateral direction between the photodiode and the memory unit. For example, when a vertical trench extending in a longitudinal direction from a front surface or a back surface of a substrate is formed, and a horizontal trench extending in a lateral direction from the vertical trench is formed, the horizontal trench can be formed between the photodiode and the memory unit. Then, a material of the light-blocking unit is embedded into the vertical trench and the horizontal trench, and thus the light-blocking unit can be formed in the horizontal trench. In this case, there is a problem that the vertical trench may reduce the layout efficiency of the integrated circuit, for example, by the vertical trench interfering with arrangement of other components.

Therefore, the present disclosure provides a solid-state imaging device that can minimize a decrease in layout efficiency due to trenches and a method of producing the same.

### [Solution to Problem]

According to a first aspect the present invention provides a solid-state imaging device in accordance with claim 1. According to a second aspect the present invention provides a solid-state imaging device in accordance with claim 10. According to a third aspect the present invention provides a solid-state imaging device in accordance with claim 13. According with a fourth aspect the present invention provides a method in accordance with claim 15. Further aspects are set forth in the dependent claims, the drawings, and the following description. A solid-state imaging device according to a first aspect of the present disclosure includes a substrate including one or more vertical trenches extending in a longitudinal direction and a horizontal trench that extends in a lateral direction and is connected to the one or more vertical trenches, the horizontal trench being provided between a photoelectric conversion unit and a charge holding unit in the substrate and including a light-blocking film, and the one or more vertical trenches including a first trench having a first width and including the light-blocking film, and a second trench having a second width narrower than the first width and not including the light-blocking film, or a third trench including a first part having a third width and including the light-blocking film and a second part having a fourth width narrower than the third width and not including the light-blocking film. Thereby, it is possible to minimize a decrease in layout efficiency due to the trenches.

In addition, in the first aspect, the first trench may include an element separation insulating film and the light-blocking film, and the second trench may include the element separation insulating film and may not include the light-blocking film. Thereby, the first and second trenches can function as element separation units.

In addition, in the first aspect, the light-blocking film may be provided between fixed charge films in the horizontal trench. Thereby, the dark current can be reduced in the vicinity of the light-blocking film.

In addition, in the first aspect, the horizontal trench may include the light-blocking film and a cavity provided between the light-blocking films. Thereby, it is possible to reduce the amount of the light-blocking film used and it is possible to minimize the warpage of the substrate due to the light-blocking film.

In addition, in the first aspect, the thickness between a top surface and a bottom surface of the light-blocking film in the horizontal trench may be equal to or larger than the first width of the first trench. Thereby, it is possible to narrow the width of the first trench while providing a sufficient amount of the light-blocking film in the horizontal trench.

In addition, the solid-state imaging device of the first aspect may further include one or more electrodes that are provided on the substrate and overlap on the second trench. Thereby, it is possible to improve the layout efficiency of the electrode.

In addition, in the first aspect, the first part may include an element separation insulating film and the light-blocking film, and the second part may include the element separation insulating film and may not include the light-blocking film. Thereby, the first and second parts of the third trench can function as the element separation unit.

In addition, in the first aspect, the first part may be provided at a boundary part of a mirror layout of one or more electrodes provided on the substrate. Thereby, the arrangement of the first part can be arranged with favorable symmetry.

In addition, in the first aspect, the substrate may periodically include the plurality of first parts at the boundary part, and a layout cycle of the first part may be the same as a layout cycle of pixels with the same color in the substrate. Thereby, properties of pixels with the same color can be matched.

In addition, in the first aspect, the first part may be provided outside a pixel array region. Thereby, it is possible to improve the layout efficiency inside the pixel array region.

In addition, in the first aspect, the substrate may be a silicon {111} substrate, and the one or more vertical trenches may extend in a lateral direction orthogonal to the <110> direction. This makes it easier to form the horizontal trench, for example, in the silicon {111} substrate.

In addition, in the first aspect, the one or more vertical trenches may include both a trench extending from a front surface of the substrate in a longitudinal direction and a trench extending from a back surface of the substrate in the longitudinal direction. This makes it easier to embed the light-blocking film, for example, in the horizontal trench.

A solid-state imaging device according to a second aspect of the present disclosure includes a substrate including one or more vertical trenches extending in a longitudinal direction and a horizontal trench that extends in a lateral direction and is connected to the one or more vertical trenches, the horizontal trench being provided between a photoelectric conversion unit and a charge holding unit in the substrate and including a light-blocking film, and the one or more vertical trenches including a fourth trench including a first region in which a plug is provided on the light-blocking film in the first region, which is a first region including the light-blocking film, and a second region in which no plug is provided on the light-blocking film in the second region, which is a second region including the light-blocking film, and further including a wiring that is provided above the light-blocking film in the second region and electrically insulated from the plug on the light-blocking film in the first region. Thereby, it is possible to minimize a decrease in layout efficiency due to trenches.

In addition, in the second aspect, each of the first region and the second region may include an element separation insulating film and the light-blocking film. Thereby, the first and second regions of the fourth trench can function as element separation units.

In addition, in the second aspect, the first region and the second region may have the same width. This makes it easier to form, for example, the fourth trench including the first and second regions.

In addition, in the second aspect, the substrate may be a silicon {111} substrate, and the one or more vertical trenches may extend in a lateral direction orthogonal to the <110> direction. This makes it easier to form the horizontal trench, for example, in the silicon {111} substrate.

A solid-state imaging device according to a third aspect of the present disclosure includes a substrate including one or more vertical trenches extending in a longitudinal direction and a horizontal trench that extends in a lateral direction and is connected to the one or more vertical trenches, the horizontal trench being provided between a photoelectric conversion unit and a charge holding unit in the substrate and including a light-blocking film, wherein the one or more vertical trenches include a first trench having a first width and including the light-blocking film, and the thickness between a top surface and a bottom surface of the light-blocking unit in the horizontal trench is equal to or larger than the first width of the first trench. Thereby, it is possible to minimize a decrease in layout efficiency due to trenches and it is possible to restrain the parasitic sensitivity caused by leakage of light to the charge holding unit generated by a diffraction phenomenon when incident light passes from the back surface of the substrate through the gap between the horizontal trenches.

In addition, in the third aspect, the horizontal trench may include the light-blocking film and a cavity provided between the light-blocking films. Thereby, it is possible to reduce the amount of the light-blocking film used and it is possible to minimize the warpage of the substrate due to the light-blocking film.

In addition, in the third aspect, the one or more vertical trenches may include both a trench extending from a front surface of the substrate in a longitudinal direction and a trench extending from a back surface of the substrate in the longitudinal direction. This makes it easier to embed the light-blocking film, for example, in the horizontal trench.

In addition, in the third aspect, the one or more vertical trenches may further include a second trench having a second width narrower than the first width and not including the light-blocking film, and each of the trench extending from a front surface of the substrate in a longitudinal direction and the trench extending from a back surface of the substrate in the longitudinal direction may be either the first trench or the second trench. Thereby, for example, the trench for embedding the light-blocking film can be limited to a part of the trench, and it is possible to minimize a decrease in layout efficiency due to trenches.

A method of producing a solid-state imaging device according to a fourth aspect of the present disclosure includes forming one or more vertical trenches extending in a longitudinal direction in a substrate; forming a horizontal trench that extends in a lateral direction in the substrate and is connected to the one or more vertical trenches; and forming a light-blocking film in the horizontal trench, wherein the one or more vertical trenches are formed to include a first trench having a first width and including the light-blocking film, and a second trench having a second width narrower than the first width and not including the light-blocking film, or a third trench including a first part having a third width and including the light-blocking film and a second part having a fourth width narrower than the third width and not including the light-blocking film. Thereby, it is possible to minimize a decrease in layout efficiency due to trenches.

### [Brief Description of Drawings]

[Fig. 1]

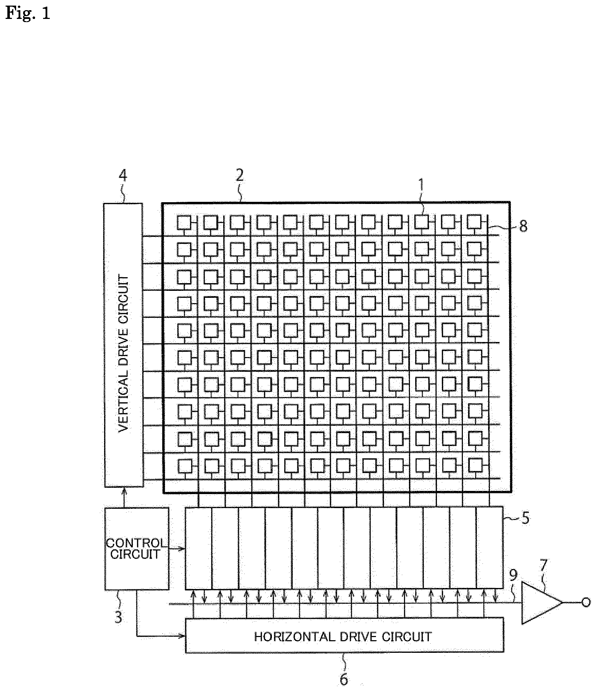

   Fig. 1 is a block diagram showing a configuration of a solid-state imaging device of a first embodiment.
[Fig. 2]

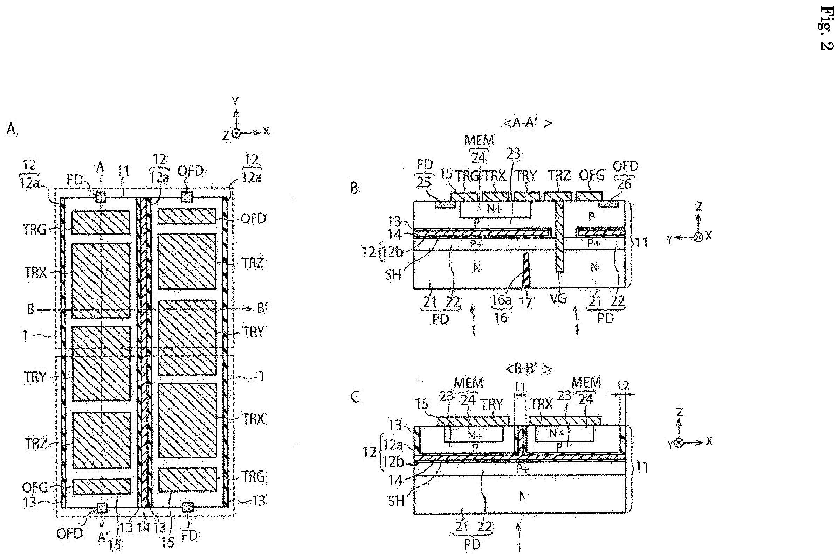

   Fig. 2 shows cross-sectional views of a structure of the solid-state imaging device of the first embodiment.
[Fig. 3]

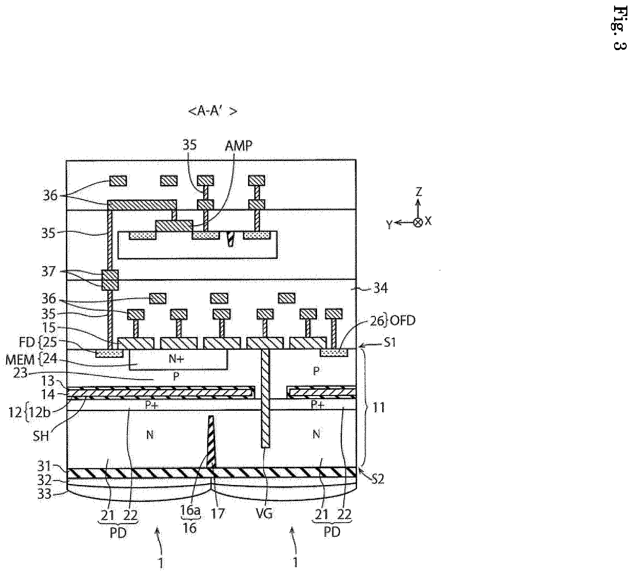

   Fig. 3 is a cross-sectional view showing the overall structure of the solid-state imaging device of the first embodiment.
[Fig. 4]

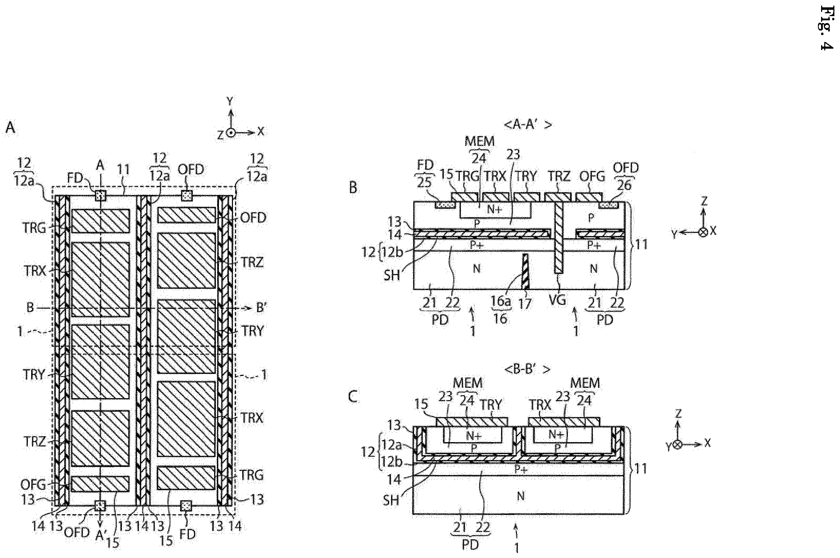

   Fig. 4 shows cross-sectional views of a structure of a solid-state imaging device of a comparative example of the first embodiment.
[Fig. 5]

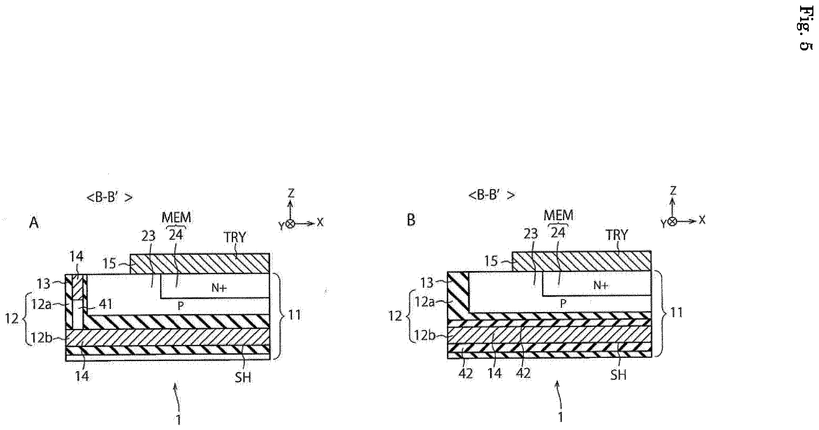

   Fig. 5 shows cross-sectional views of structures of solid-state imaging devices of first and second modification examples of the first embodiment.
[Fig. 6]

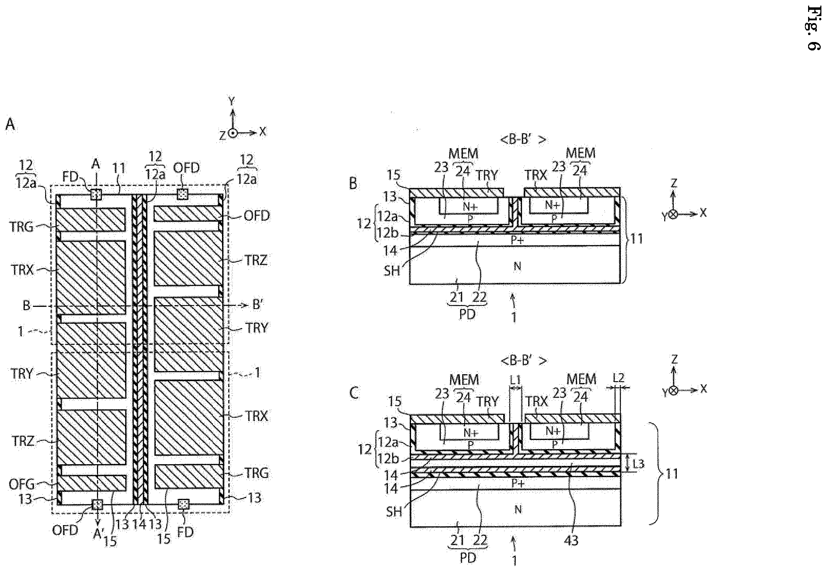

   Fig. 6 shows cross-sectional views of a structure of a solid-state imaging device of a third modification example of the first embodiment.
[Fig. 7]

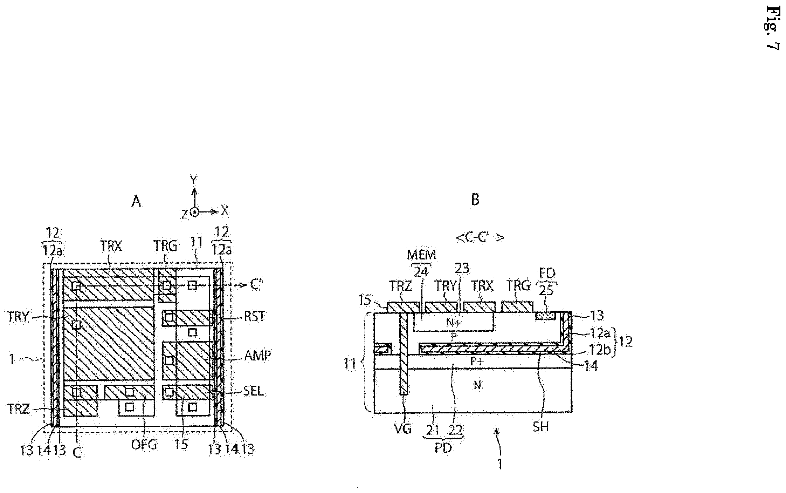

   Fig. 7 shows cross-sectional views of a structure of a solid-state imaging device of a fourth modification example of the first embodiment.
[Fig. 8]

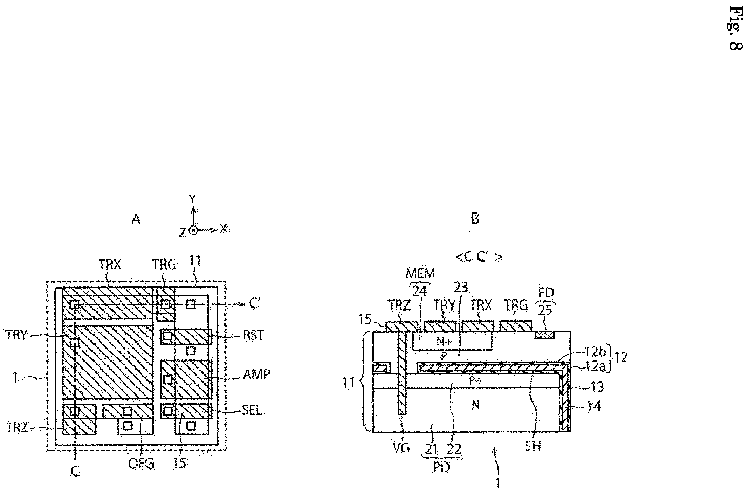

   Fig. 8 shows cross-sectional views of a structure of a solid-state imaging device of a fifth modification example of the first embodiment.
[Fig. 9]

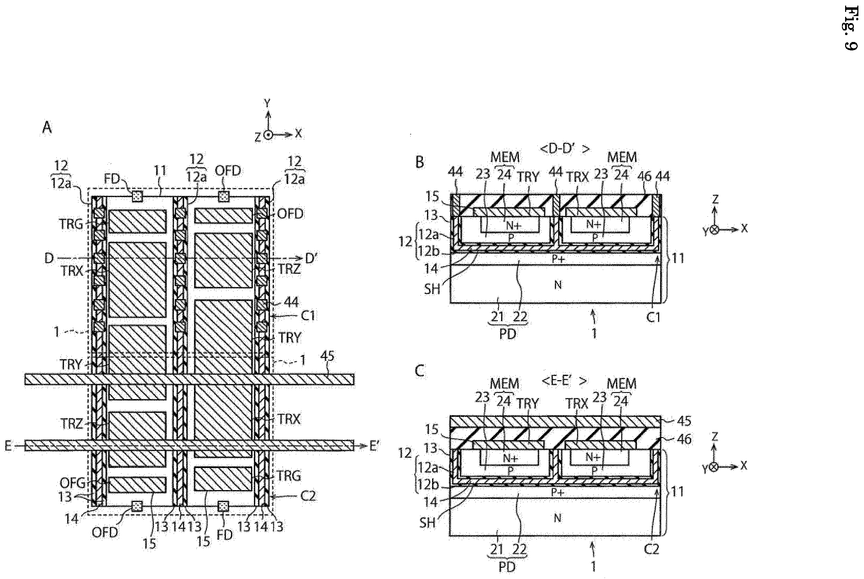

   Fig. 9 shows cross-sectional views of a structure of a solid-state imaging device of a second embodiment.
[Fig. 10]

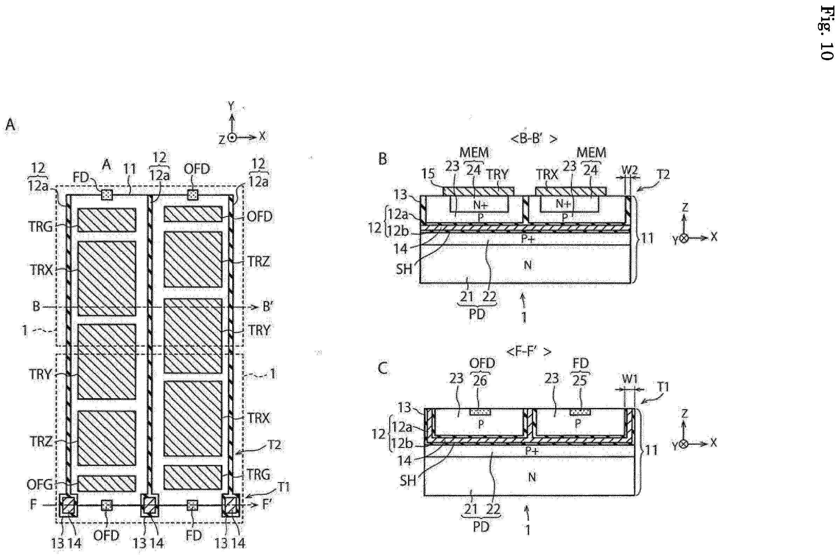

   Fig. 10 shows cross-sectional views of a structure of a solid-state imaging device of a third embodiment.
[Fig. 11]

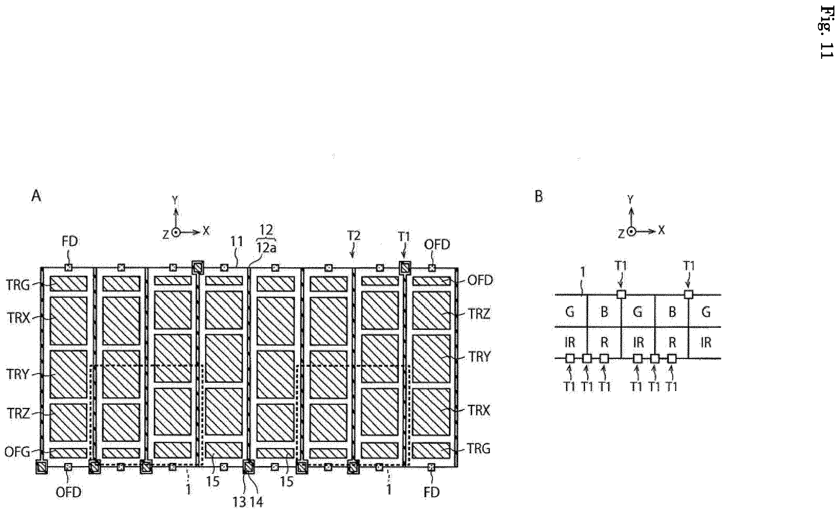

   Fig. 11 shows cross-sectional views of an example of the overall structure of the solid-state imaging device of the third embodiment.
[Fig. 12]

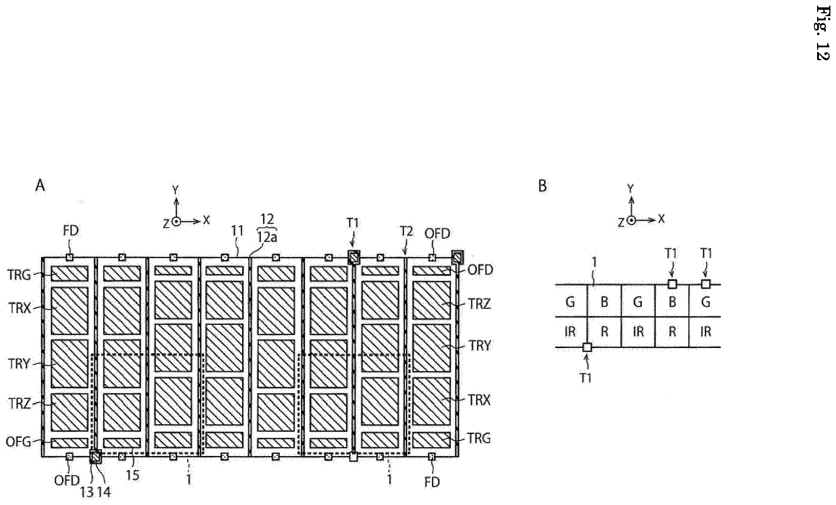

   Fig. 12 shows cross-sectional views of another example of the overall structure of the solid-state imaging device of the third embodiment.
[Fig. 13]

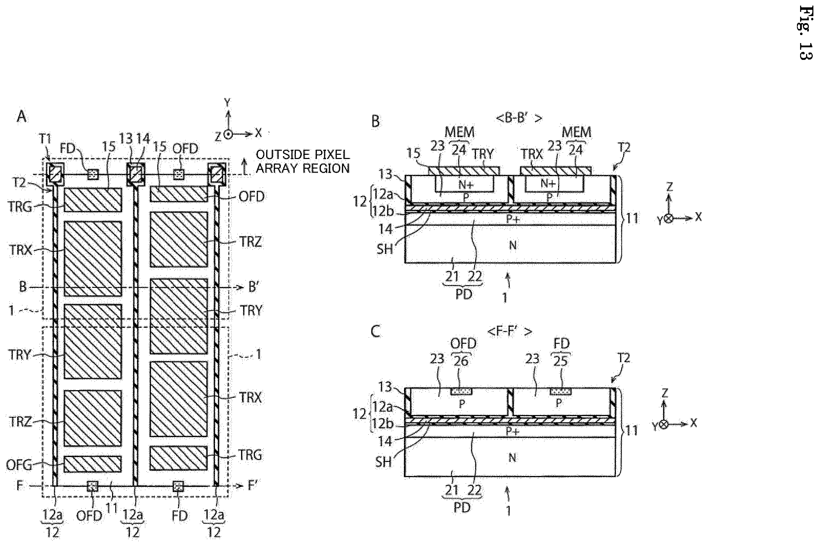

   Fig. 13 shows cross-sectional views of a structure of a solid-state imaging device of a modification example of the third embodiment.
[Fig. 14]

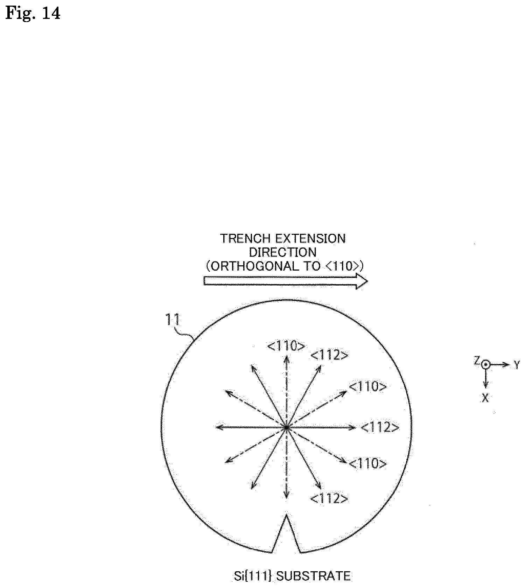

   Fig. 14 is a plan view for illustrating a structure of a solid-state imaging device of a fourth embodiment.
[Fig. 15]

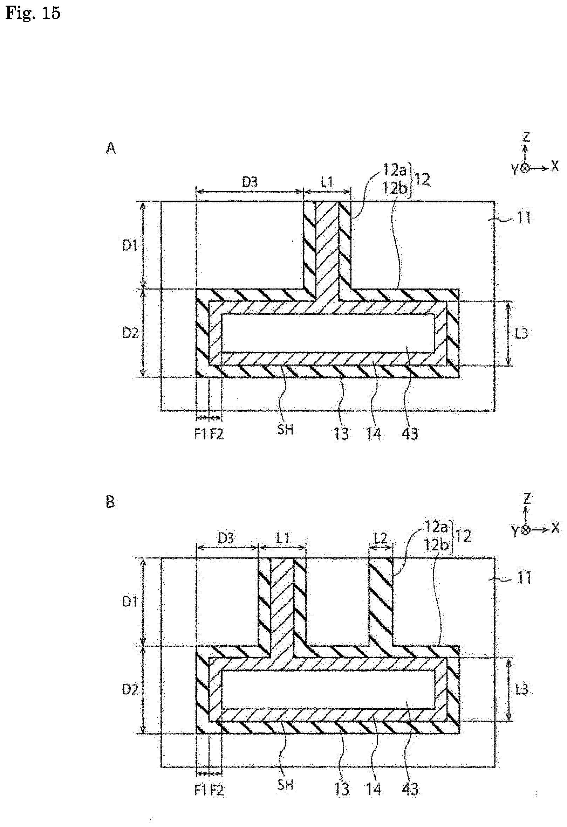

   Fig. 15 shows cross-sectional views of a structure of a solid-state imaging device of a fifth embodiment.
[Fig. 16]

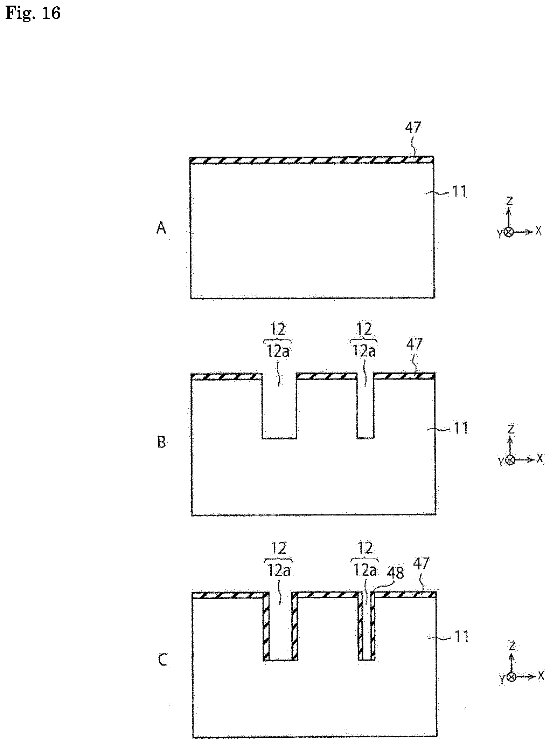

   Fig. 16 shows cross-sectional views (1/3) illustrating a method of producing the solid-state imaging device of the fifth embodiment.
[Fig. 17]

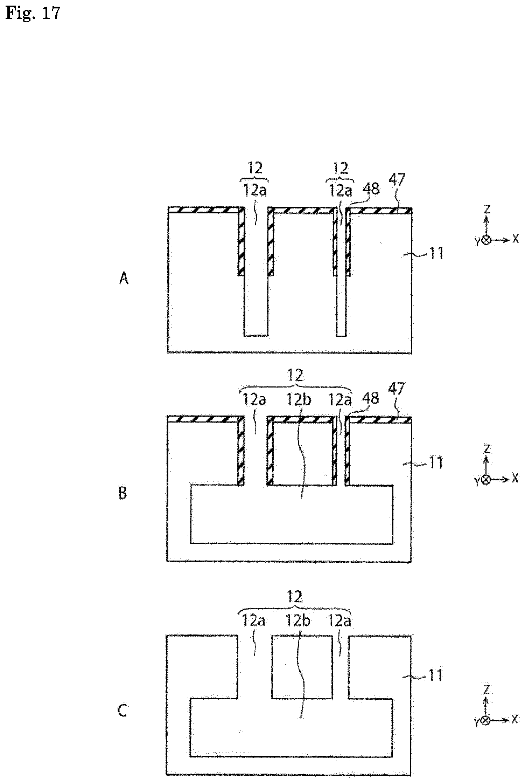

   Fig. 17 shows cross-sectional views (2/3) illustrating the method of producing the solid-state imaging device of the fifth embodiment.
[Fig. 18]

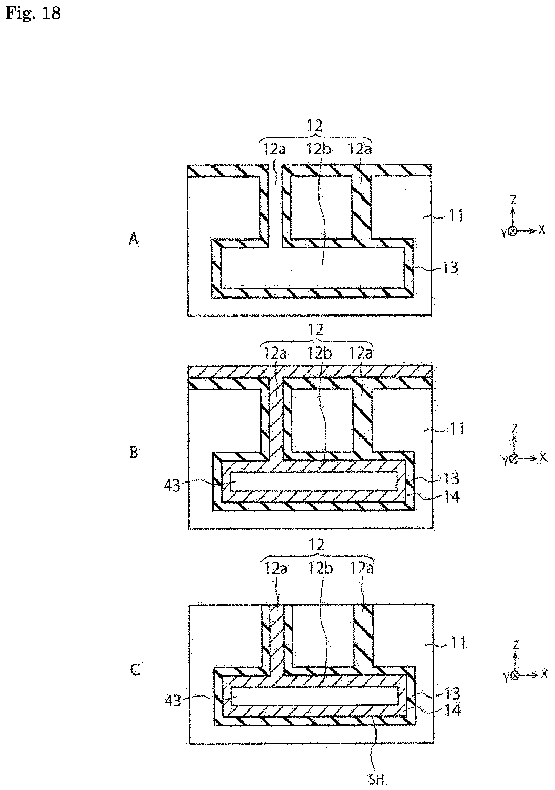

   Fig. 18 shows cross-sectional views (3/3) illustrating the method of producing the solid-state imaging device of the fifth embodiment.
[Fig. 19]

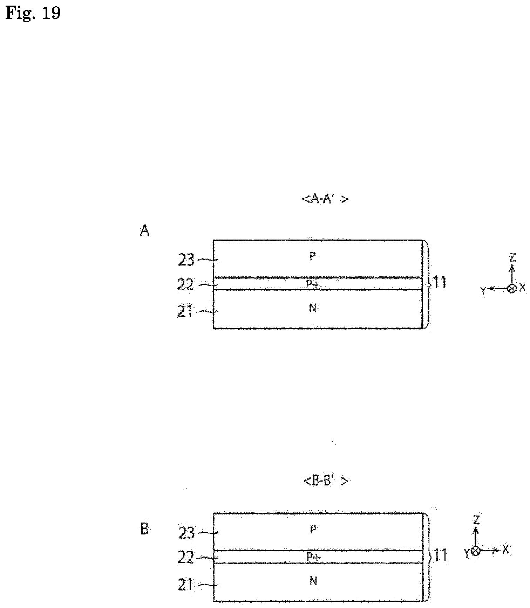

   Fig. 19 shows cross-sectional views (1/3) illustrating details of the method of producing the solid-state imaging device of the fifth embodiment.
[Fig. 20]

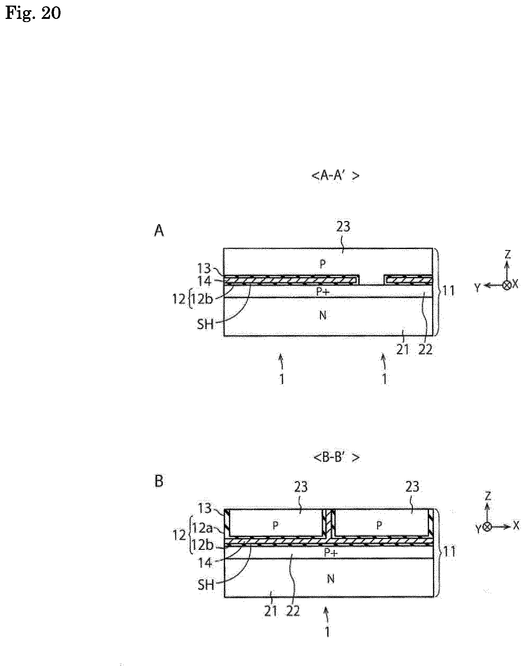

   Fig. 20 shows cross-sectional views (2/3) illustrating details of the method of producing the solid-state imaging device of the fifth embodiment.
[Fig. 21]

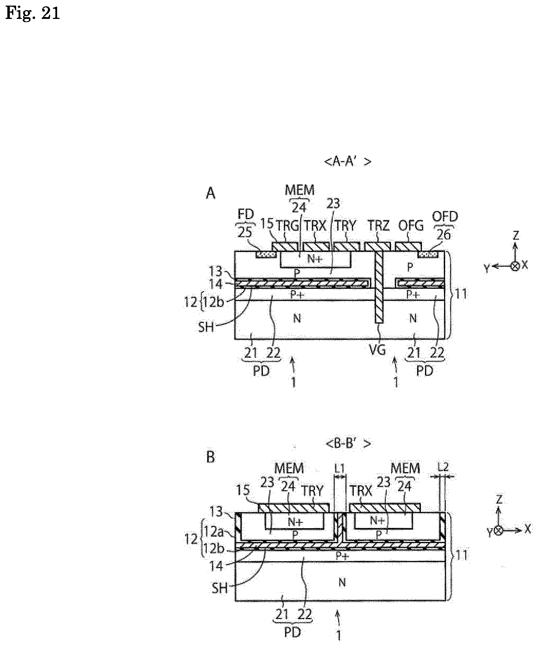

   Fig. 21 shows cross-sectional views (3/3) illustrating details of the method of producing the solid-state imaging device of the fifth embodiment.
[Fig. 22]

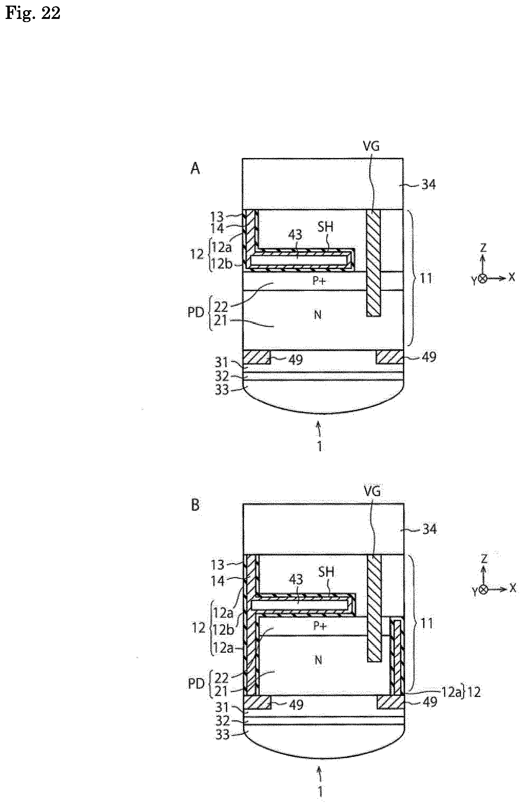

   Fig. 22 shows cross-sectional views of structures of solid-state imaging devices of first and second modification examples of the fifth embodiment.
[Fig. 23]

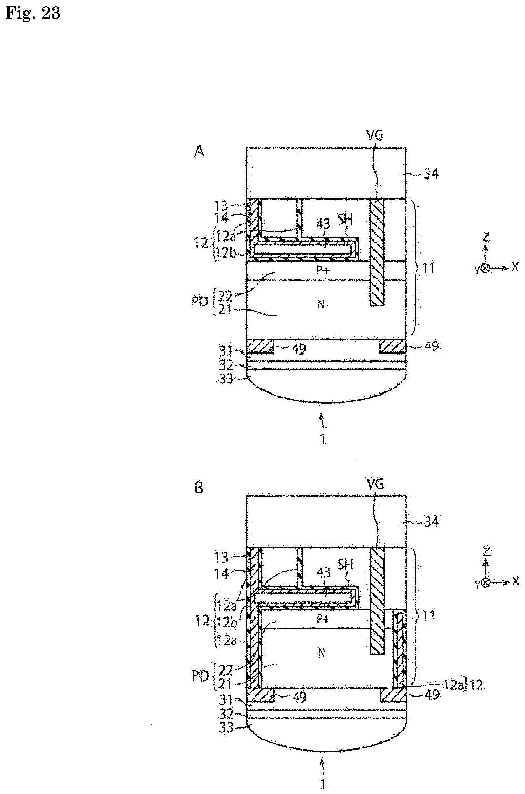

   Fig. 23 shows cross-sectional views of structures of solid-state imaging devices of third and fourth modification examples of the fifth embodiment.
[Fig. 24]

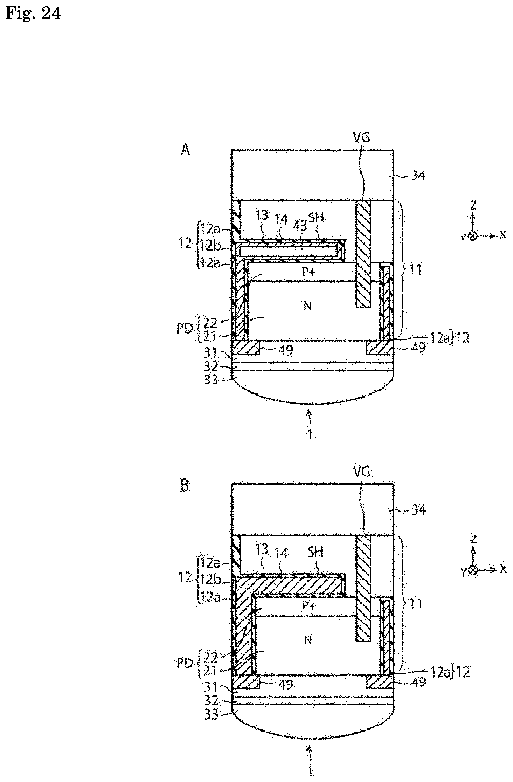

   Fig. 24 shows cross-sectional views of structures of solid-state imaging devices of fifth and sixth modification examples of the fifth embodiment.
[Fig. 25]

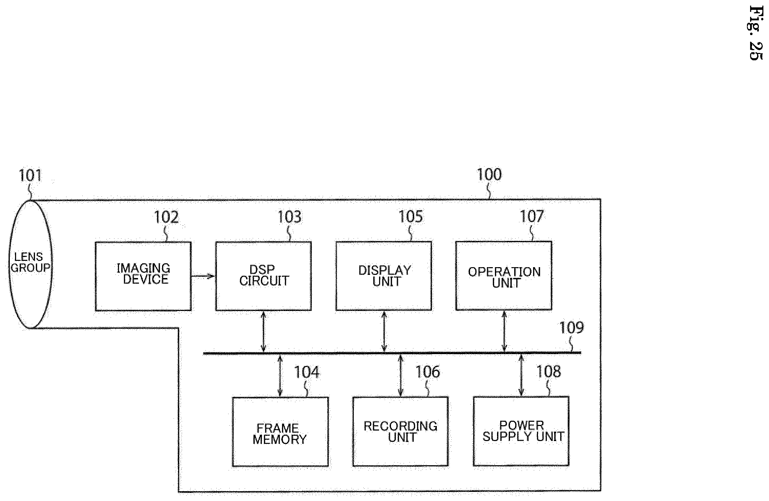

   Fig. 25 is a block diagram showing a configuration example of an electronic device.
[Fig. 26]

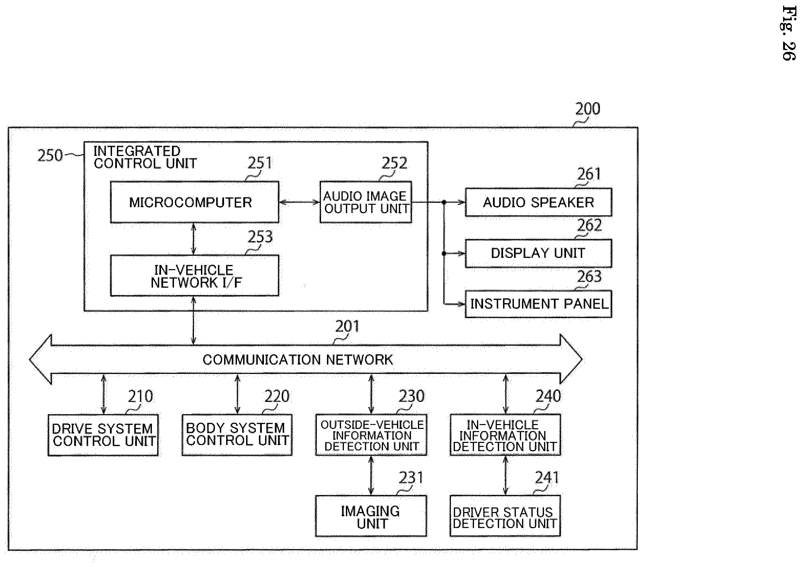

   Fig. 26 is a block diagram showing a configuration example of a mobile control system.
[Fig. 27]

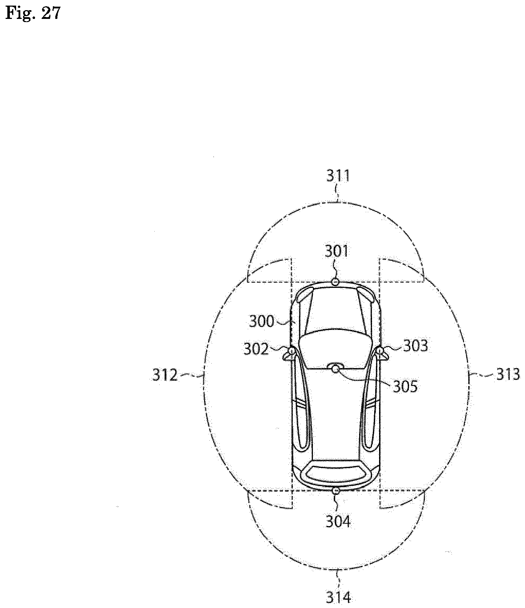

   Fig. 27 is a plan view showing a specific example of setting positions of imaging units in Fig. 26.
[Fig. 28]

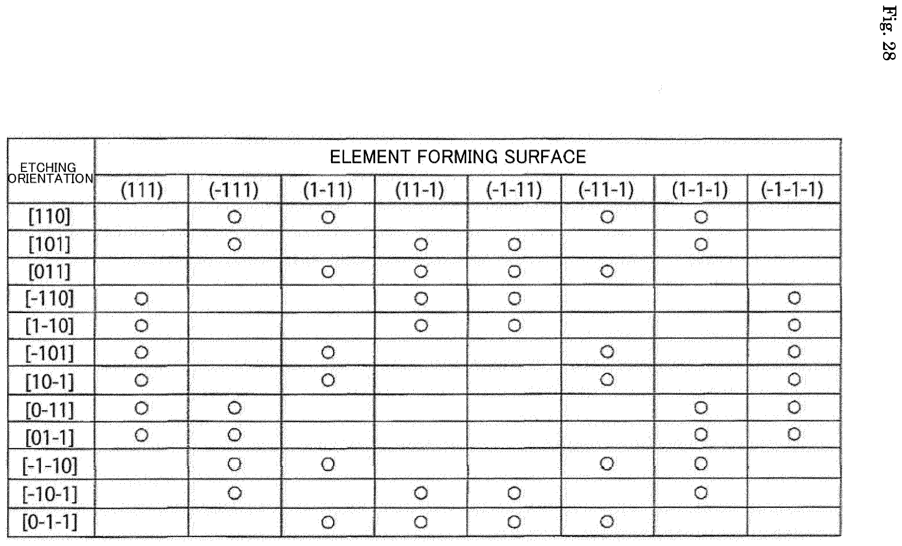

   Fig. 28 is a table for illustrating etching of the Si{111} substrate in the present disclosure.
[Fig. 29]

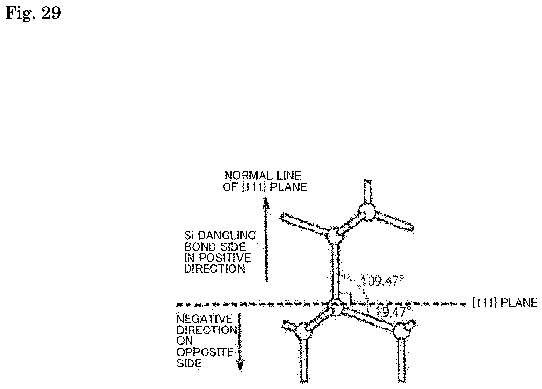

   Fig. 29 is a schematic diagram illustrating back bonds on the crystal plane of the Si substrate of the present disclosure.
[Fig. 30]

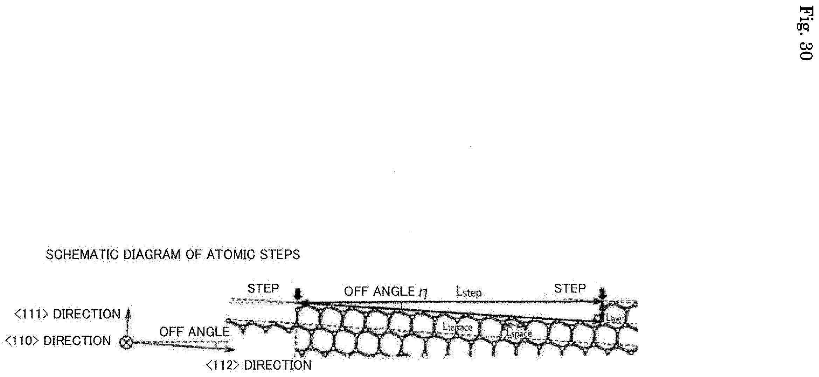

   Fig. 30 is a schematic diagram illustrating an off angle on the front surface of the Si substrate of the present disclosure.

### [Description of Embodiments]

Hereinafter, embodiments of the present invention will be described with reference to the drawings.

### (First embodiment)

Fig. 1 is a block diagram showing a configuration of a solid-state imaging device of a first embodiment.

The solid-state imaging device in Fig. 1 is a complementary metal oxide semiconductor (CMOS) type solid-state imaging device, and includes a pixel array region 2 having a plurality of pixels 1, a control circuit 3, a vertical drive circuit 4, a plurality of column signal processing circuits 5, a horizontal drive circuit 6, an output circuit 7, a plurality of vertical signal lines 8, and a horizontal signal line 9.

Each pixel 1 includes a photoelectric conversion unit and a plurality of pixel transistors. The photoelectric conversion unit is, for example, a photodiode. The pixel transistor is, for example, an MOS transistor such as a transfer transistor, a reset transistor, an amplifying transistor, and a select transistor. Each pixel 1 of the present embodiment includes, as transfer transistors, five MOS transistors: TRZ, TRY, TRX, TRG, and OFG.

The pixel array region 2 has a plurality of pixels 1 arranged in a 2D array form. The pixel array region 2 includes an effective pixel region in which light is received, photoelectric conversion is performed, and a signal charge generated by the photoelectric conversion is amplified and output, and a black reference pixel region (not shown) for outputting optical black, which is a reference for the black level. Generally, the black reference pixel region is arranged on an outer peripheral part of the effective pixel region.

The control circuit 3 generates various signals that serve as references for the operation of the vertical drive circuit 4, the column signal processing circuit 5, the horizontal drive circuit 6 and the like based on a vertical synchronization signal, a horizontal synchronization signal, and a master clock. The signal generated by the control circuit 3 is, for example, a clock signal or a control signal, and is input to the vertical drive circuit 4, the column signal processing circuit 5, the horizontal drive circuit 6 and the like.

The vertical drive circuit 4 includes, for example, a shift register, and sequentially selects and scans the pixels 1 in the pixel array region 2 in a row unit in the vertical direction. The vertical drive circuit 4 additionally supplies a pixel signal based on the signal charge generated by each pixel 1 according to the intensity of the light received to the column signal processing circuit 5 through the vertical signal line 8.

The column signal processing circuit 5 is, for example, arranged for each column of the pixel 1 in the pixel array region 2, and performs signal processing of the signal output from the pixel 1 for one row based on the signal from the black reference pixel region for each row. The signal processing is, for example, noise removal and signal amplification. A horizontal selection switch (not shown) is provided between the output end of the column signal processing circuit 5 and the horizontal signal line 9.

The horizontal drive circuit 6 includes, for example, a shift register, and sequentially outputs a horizontal scanning pulse and thus selects each of the column signal processing circuits 5 in order, and outputs a pixel signal from each of the column signal processing circuits 5 to the horizontal signal line 9.

The output circuit 7 performs signal processing on the signal sequentially supplied from each of the column signal processing circuits 5 through the horizontal signal line 9, and outputs the signal on which the signal processing has been performed.

Fig. 2 is a cross-sectional view showing the structure of the solid-state imaging device of the first embodiment. Fig. 2A shows a lateral cross section of the pixel array region 2 in Fig. 1. Fig. 2B shows a longitudinal cross section taken along the line A-A' shown in Fig. 2A. Fig. 2C shows a longitudinal cross section taken along the line B-B' shown in Fig. 2A.

The solid-state imaging device of the present embodiment includes a photodiode PD, a memory unit MEM, a floating diffusion unit FD, another diffusion unit OFD, a light-blocking unit SH, a first transfer transistor TRZ, a second transfer transistor TRY, a third transfer transistor TRX, a fourth transfer transistor TRG, and a fifth transfer transistor (discharge transistor) OFG.

The solid-state imaging device of the present embodiment further includes a substrate 11, a trench 12 including a plurality of vertical trenches 12a and a horizontal trench 12b, an element separation insulating film 13, a light-blocking film 14, a gate electrode 15 of each transistor, a trench 16 including a vertical trench 16a, and an element separation insulating film 17. The reference numeral VG indicates a vertical gate electrode included in the gate electrode 15 of the first transfer transistor TRZ. The substrate 11 includes an N-type semiconductor region 21, a P+type semiconductor region 22, a P-type semiconductor region 23, an N+type semiconductor region 24, an N+type semiconductor region 25, and an N+type semiconductor region 26.

Fig. 2 shows the X axis, the Y axis, and the Z axis that are perpendicular to each other. The X direction and the Y direction correspond to the lateral direction (horizontal direction), and the Z direction corresponds to the longitudinal direction (vertical direction). In addition, the +Z direction corresponds to the upward direction, and the -Z direction corresponds to the downward direction. The -Z direction may exactly match the gravity direction, or may not exactly match the gravity direction.

Hereinafter, the structure of the solid-state imaging device of the present embodiment will be described with reference to Figs. 2A, 2B, and 2C. Figs. 2A and 2B show a lateral cross section and a longitudinal cross section of two pixels 1 in the pixel array region 2. Fig. 2C shows a longitudinal cross section of one pixel 1 between these two pixels 1.

The substrate 11 is, for example, a semiconductor substrate such as a silicon (Si) substrate. In Figs. 2B and 2C, the surface of the substrate 11 in the +Z direction is a front surface of the substrate 11, and the surface of the substrate 11 in the -Z direction is a back surface of the substrate 11. Since the solid-state imaging device of the present embodiment is of a back-illuminated type, the back surface of the substrate 11 is a light incident surface of the substrate 11. The thickness of the substrate 11 is, for example, 1 to 6 pm. The substrate 11 may be, for example, a substrate including a semiconductor substrate and a semiconductor layer formed on the semiconductor substrate.

The substrate 11 includes an impurity semiconductor region such as the N-type semiconductor region 21. The P+type semiconductor region 22 is provided on the N-type semiconductor region 21. The P-type semiconductor region 23 is provided on the P+type semiconductor region 22. The N+type semiconductor region 24, the N+type semiconductor region 25, and the N+type semiconductor region 26 are provided on the P-type semiconductor region 23, and are exposed on the front surface of the substrate 11.

The photodiode PD includes the N-type semiconductor region 21 and the P+type semiconductor region 22 which form a PN junction, and functions as a photoelectric conversion unit that converts received light into a charge to generate a signal charge. The photodiode PD is provided in the substrate 21 for each pixel 1.

The memory unit MEM includes the N+type semiconductor region 24, and functions as a charge holding unit that holds a signal charge generated by the photodiode PD. The signal charge is stored in the N+type semiconductor region 24. Fig. 2A shows two pixels 1 adjacent to each other in the Y direction, and Fig. 2C shows two memory units MEM adjacent to each other in the X direction. For these pixels 1 and the memory units MEM, the memory unit MEM in the -X direction in Fig. 2C functions as a charge holding unit for the pixel 1 in the +Y direction in Fig. 2A, and the memory unit MEM in the +X direction in Fig. 2C functions as a charge holding unit for the pixel 1 in the -Y direction in Fig. 2A. Each of these memory units MEM is arranged over both of these pixels 1.

The floating diffusion unit FD includes the N+type semiconductor region 25, and functions as a charge-voltage conversion unit that converts the signal charge transferred from the memory unit MEM into a voltage signal and outputs it. Similarly, the diffusion unit OFD includes the N+type semiconductor region 26. In Fig. 2A, the floating diffusion unit FD in the +Y direction and the diffusion unit OFD in the -Y direction are provided for the pixel 1 in the +Y direction, and the floating diffusion unit FD in the -Y direction and the diffusion unit OFD in the +Y direction are provided for the pixel 1 in the -Y direction.

In this manner, the solid-state imaging device of the present embodiment uses a global shutter (GS) type, and includes the memory unit MEM in addition to the photodiode PD and the floating diffusion unit FD for each pixel 1. In addition, in the solid-state imaging device of the present embodiment, in order to reduce the area of the integrated circuit, a laminated structure in which the memory unit MEM is arranged in the longitudinal direction instead of the lateral direction of the photodiode PD is used.

The trench 12 includes the plurality of vertical trenches 12a and the horizontal trench 12b formed in the substrate 11. These vertical trenches 12a extend from the front surface of the substrate 11 in the longitudinal direction (-Z direction) as shown in Fig. 2C and extend in the Y direction and are adjacent to each other in the X direction as shown in Fig. 2A. The horizontal trench 12b is connected to these vertical trenches 12a as shown in Figs. 2B and 2C, and extends from these vertical trenches 12a in the lateral direction (±X direction and ±Y direction). The horizontal trench 12b of the present embodiment has a plate shape that extends in the XY plane, and is provided between the photodiode PD and the memory unit MEM (in addition, between the photodiode PD and the floating diffusion unit FD, and between the photodiode PD and the diffusion unit OFD). However, the horizontal trench 12b of the present embodiment has an opening below the gate electrode 15 of the first transfer transistor TRZ, and the vertical gate electrode VG passes through the opening.

The vertical trench 12a of the present embodiment includes the vertical trench 12a having a thick width L1 and the vertical trench 12a having a narrow width L2. The vertical trench 12a having a thick width L1 is an example of a first trench having a first width. The vertical trench 12a having a narrow width L2 is an example of a second trench having a second width narrower than the first width. Figs. 2A and 2C show, as an example, one first trench and two second trenches.

The element separation insulating film 13 is embedded in the trench 12, and formed on the side surface, the top surface, and the bottom surface of the trench 12. The element separation insulating film 13 is used as an insulating film for separating the pixels 1 from each other. The element separation insulating film 13 is, for example, a silicon oxide film (SiO₂).

Like the element separation insulating film 13, the light-blocking film 14 is embedded in the trench 12, and formed on the side surface, the top surface, and the bottom surface of the trench 12 with the element separation insulating film 13 therebetween. The light-blocking film 14 is used to block light from the back surface of the substrate 11 and optically separate the photodiode PD and the memory unit MEM. The light-blocking film 14 is, for example, a metal layer such as a tungsten (W) layer or a compound semiconductor layer having a chalcopyrite structure having a high absorption coefficient.

In the present embodiment, the vertical trench 12a having a thick width L1 (the first trench) includes the element separation insulating film 13 and the light-blocking film 14, and the element separation insulating film 13 in the first trench functions as an element separation unit that separates the pixels 1 from each other. On the other hand, the vertical trench 12a having a narrow width L2 (the second trench) includes the element separation insulating film 13, and does not include the light-blocking film 14, but the element separation insulating film 13 in the second trench functions as an element separation unit that separates the pixels 1 from each other as in the element separation insulating film 13 in the first trench. Here, although the light-blocking film 14 is not the element separation insulating film 13, since the light-blocking film 14 in the first trench is provided between the element separation insulating films 13, the light-blocking film 14 in the first trench functions as an element separation unit together with the element separation insulating film 13. Therefore, the element separation unit in the first trench has a thick width L1, and the element separation unit in the second trench has a narrow width L2.

In addition, in the present embodiment, the horizontal trench 12b includes the element separation insulating film 13 and the light-blocking film 14, and the light-blocking film 14 in the horizontal trench 12b functions as a light-blocking unit SH that optically separates the photodiode PD and the memory unit MEM. Here, the light-blocking film 14 in the horizontal trench 12b is provided between the element separation insulating films 13.

The gate electrode 15 is provided on the substrate 11 with a gate insulating film (not shown) therebetween, and is included in the first transfer transistor TRZ, the second transfer transistor TRY, the third transfer transistor TRX, the fourth transfer transistor TRG, and the fifth transfer transistor OFG. The gate electrode 15 is, for example, semiconductor layer such as a silicon (Si) layer or a metal layer such as a tungsten (W) layer, an aluminum (Al) layer, a copper (Cu) layer, or a metal silicide layer. The gate electrode 15 of the first transfer transistor TRZ includes a vertical gate electrode VG provided in the P-type semiconductor region 23, the P+type semiconductor region 22, and the N-type semiconductor region 21 of the substrate 11.

The first transfer transistor TRZ transfers a signal charge from the photodiode PD to the memory unit MEM. The second transfer transistor TRY and the third transfer transistor TRX transfer signal charges inside the memory unit MEM. The fourth transfer transistor TRG transfers a signal charge from the memory unit MEM to the floating diffusion unit FD. The fifth transfer transistor OFG is provided between the photodiode PD and the diffusion unit OFD, and is used to initialize the photodiode PD, that is, to reset the potential of the photodiode PD to a power supply potential (VDD potential). Here, the semiconductor device of the present embodiment may include only the third transfer transistor TRX between the second transfer transistor TRY and the third transfer transistor TRX. The semiconductor device including TRY and TRX has better signal charge transfer performance, but the semiconductor device including only TRX makes the structure of the semiconductor device simpler.

In Fig. 2A, TRZ, TRY, TRX, TRG, and OFG in the +X direction are transfer transistors for the pixel 1 in the -Y direction, and TRZ, TRY, TRX, TRG, and OFG in the -X direction are transfer transistors for the pixel 1 in the +Y direction. The former transfer transistor is arranged in the order of TRG, TRX, TRY, TRZ, and OFG in the +Y direction, the latter transfer transistor is arranged in the order of OFG, TRZ, TRY, TRX, and TRG in the +Y direction, and these transfer transistors are arranged in a mirror layout centered on the vertical trench 12a having a thick width L1. Fig. 2A shows a state in which the gate electrodes 15 of these transfer transistors are arranged by a mirror layout.

The trench 16 includes the vertical trench 16a formed in the substrate 11. As shown in Fig. 2B, the vertical trench 16a extends from the back surface of the substrate 11 in the longitudinal direction (+Z direction).

The element separation insulating film 17 is embedded in the trench 16, and is formed on the side surface and the bottom surface (top surface) of the trench 16. The element separation insulating film 17 is used as an insulating film for separating the pixels 1 from each other. The element separation insulating film 17 is, for example, a silicon oxide film (SiOz). The trench 16 of the present embodiment includes the element separation insulating film 17, and the element separation insulating film 17 in the trench 16 functions as an element separation unit that separates the pixels 1 from each other.

As described above, the solid-state imaging device of the present embodiment includes the light-blocking film 14 in the horizontal trench 12b. Thereby, the photodiode PD and the memory unit MEM can be optically separated by the light-blocking unit SH in the horizontal trench 12b.

In the present embodiment, in order to form the light-blocking unit SH, the light-blocking film 14 is formed in the horizontal trench 12b with the vertical trench 12a therebetween. Therefore, the trench 12 of the present embodiment includes the vertical trench 12a having a thick width L1. In this case, there is a problem that the vertical trench 12a may reduce the layout efficiency of the integrated circuit, for example, by the vertical trench 12a interfering with arrangement of other components.

Therefore, the vertical trench 12a of the present embodiment is formed so that it includes the vertical trench 12a having a thick width L1 and the vertical trench 12a having a narrow width L2. Thereby, the light-blocking film 14 can be formed in the horizontal trench 12b with the vertical trench 12a having a thick width L1 therebetween. In addition, by increasing the width of only a part of the vertical trench 12a rather than the width of the entire vertical trench 12a, it is possible to minimize a decrease in the layout efficiency of the integrated circuit due to the vertical trench 12a. In the present embodiment, since it is not necessary to use the vertical trench 12a having a narrow width L2 for embedding the light-blocking film 14, as shown in Figs. 2A and 2C, the light-blocking film 14 is not formed in the vertical trench 12a having a narrow width L2.

In the present embodiment, the ratio between the number of vertical trenches 12a having a thick width L1 (the first trenches) and the number of vertical trenches 12a having a narrow width L2 (the second trenches) may be set to any ratio. In Fig. 2A, the plurality of first trenches and the plurality of second trenches are alternately arranged, and the ratio between the number of first trenches and the number of second trenches is set to "1:1". For example, when the number of first trenches is reduced and the number of second trenches is increased, it is possible to further improve the layout efficiency of the integrated circuit.

Fig. 3 is a cross-sectional view showing the overall structure of the solid-state imaging device of the first embodiment.

Fig. 3 shows a flattening layer 31 provided on the back surface of the substrate 11, a color filter layer 32, an on-chip lens 33, and a laminated part 34 laminated on the front surface of the substrate 11 in addition to the components shown in Fig. 2B.

The flattening layer 31 is formed to cover the back surface of the substrate 11, and thus the surface under the back surface of the substrate 11 becomes flat. A flattening film 31 is, for example, an organic film such as a resin film.

The color filter layer 32 is provided under the flattening film 31 for each pixel 1. For example, the color filter layers 32 for red (R), green (G), blue (B), and infrared light (IR) are arranged below the photodiode PD of the red, green, blue, and infrared light pixels 1. Each color filter layer 32 has a property of being able to transmit light with a predetermined wavelength, and light transmitted through each color filter layer 32 enters the photodiode PD.

The on-chip lens 33 is provided under the color filter layer 32 for each pixel 1. Each on-chip lens 33 has a property of condensing incident light, and light condensed by each on-chip lens 33 enters the photodiode PD via the color filter layer 32.

The laminated part 34 includes a plurality of metal plugs 35, a plurality of wiring layers 36, a plurality of metal pads 37, and the like in the interlayer insulating film provided on the substrate 11. The solid-state imaging device of the present embodiment may include a reset transistor, an amplifying transistor, and a select transistor in the same layer as the transfer transistor, or may include them in a different layer from the transfer transistor. Fig. 3 shows, as an example, an amplifying transistor AMP arranged in a different layer from the transfer transistor.

Here, the substrate 11 of the present embodiment may include an impurity semiconductor region other than the impurity semiconductor region shown in Fig. 3. For example, an additional P-type semiconductor region may be provided between the N-type semiconductor region 21 and the back surface of the substrate 11. In addition, an additional P-type semiconductor region may be provided between the N-type semiconductor region 21 and the trench 16.

Fig. 4 shows cross-sectional views of a structure of a solid-state imaging device of a comparative example of the first embodiment. Figs. 4A, 4B, and 4C show cross sections corresponding to Figs. 2A, 2B, and 2C.

The solid-state imaging device of this comparative example includes the same components as the solid-state imaging device of the first embodiment, but the vertical trench 12a of this comparative example includes only the vertical trench 12a having a thick width L1 (the first trench) and does not include the vertical trench 12a having a narrow width L2 (the second trench). Therefore, the vertical trench 12a may interfere with arrangement of other components, and the vertical trench 12a may reduce the layout efficiency of the integrated circuit.

On the other hand, the vertical trench 12a of the present embodiment includes not only the vertical trench 12a having a thick width L1 (the first trench) but also the vertical trench 12a having a narrow width L2 (the second trench). Therefore, according to the present embodiment, it is possible to minimize a decrease in layout efficiency of the integrated circuit due to the vertical trench 12a while using the vertical trench 12a (the first trench) when the light-blocking film 14 is embedded in the horizontal trench 12b.

Hereinafter, various modification examples of the first embodiment will be described.

Fig. 5 shows cross-sectional views of structures of solid-state imaging devices of first and second modification examples of the first embodiment.

Fig. 5A shows a B-B' cross section of the solid-state imaging device of the first modification example, and corresponds to Fig. 2C. However, it should be noted that Fig. 5A is enlarged from Fig. 2C.

Fig. 5A shows a cavity 41 formed in the vertical trench 12a having a thick width L1 (the first trench). The first trench, which is at least a part of the trench 12 of this modification example, may include such a cavity 41. Such a cavity 41 is formed when the first trench remains without being completely filled with the light-blocking film 14, for example, when the light-blocking film 14 is embedded in the trench 12.

Fig. 5B shows a B-B' cross section of a solid-state imaging device of a second modification example, and corresponds to Fig. 2C. However, it should be noted that Fig. 5B is enlarged from Fig. 2C.

As shown in Fig. 5B, the horizontal trench 12b of this modification example includes the element separation insulating film 13, a fixed charge film 42 provided between the element separation insulating films 13, and the light-blocking film 14 provided between the fixed charge films 42. The fixed charge film 42 is a film having a negative fixed charge, and is, for example, a hafnium oxide film (HfO₂). Thereby, it is possible to reduce an amount of a dark current in the light-blocking unit SH. Such a structure can be realized, for example, by embedding the element separation insulating film 13, the fixed charge film 42, and the light-blocking film 14 in this order in the horizontal trench 12b.

Fig. 5B also shows a state in which the vertical trench 12a having a thick width L1 (the first trench) is completely filled with only the element separation insulating film 13. The first trench as a part of the trench 12 of this modification example may be completely filled with only the element separation insulating film 13 in this manner. O the other hand, the second trench as a part of the trench 12 of this modification example may be filled with the element separation insulating film 13 and the light-blocking film 14.

Here, the element separation unit and the light-blocking unit SH of the first embodiment and modification examples may be formed by forming the element separation insulating film 13 on the side surface, the top surface, and the bottom surface of the trench 12, and embedding the light-blocking film 14 in the trench 12 with an element separation insulating film 12 therebetween. In addition, the element separation unit and the light-blocking unit SH of the first embodiment and modification examples may be formed when the element separation insulating film 13 is embedded in to the trench 12, a part of the element separation insulating film 13 is removed from the trench 12, and the light-blocking film 14 is then embedded into the trench 12 via the element separation insulating film 12. The first trench completely filled with only the element separation insulating film 13 as shown in Fig. 5B may appear, for example, when the element separation unit or the light-blocking unit SH is formed by the latter method.

Fig. 6 is a cross-sectional view showing a structure of a solid-state imaging device of a third modification example of the first embodiment. Figs. 6A and 6B correspond to cross sections corresponding to Figs. 2A and 2C. In addition, Fig. 6C corresponds to the modification example in Fig. 6B.

As shown in Figs. 6A and 6B, the solid-state imaging device of this modification example includes the same components as the solid-state imaging device of the first embodiment, but the gate electrode 15 of each transistor is provided on the vertical trench 12a having a narrow width L2 (the second trench) in an overlapping manner. The reason why such overlapping is possible is that, because the second trench is filled with the element separation insulating film 13, even if the gate electrode 15 is arranged on the second trench, the gate electrode 15 is not electrically connected to the light-blocking film 14. According to this modification example, when the gate electrode 15 is provided on the second trench in an overlapping manner, it is possible to improve the layout efficiency of the gate electrode 15.

As shown in Fig. 6C, the light-blocking unit SH of this modification example may include the light-blocking film 14 and a cavity 43 provided between the light-blocking films 14. Such a light-blocking unit SH can be formed by embedding the light-blocking film 14 into the horizontal trench 12b so that the cavity 43 remains, for example, when the light-blocking film 14 is embedded into the horizontal trench 12b. Thereby, it is possible to reduce the amount of the light-blocking film 14 used for forming the light-blocking unit SH and to minimize warpage of the substrate 11 due to the light-blocking film 14. Here, although the cavity 43 is not the light-blocking film 14, since the cavity 43 in the horizontal trench 12b is provided between the light-blocking films 14, the cavity 43 in the horizontal trench 12b functions as a light-blocking unit together with the light-blocking film 14.

Fig. 6C shows the vertical trench 12a having a thick width L1 (the first trench), the vertical trench 12a having a narrow width L2 (the second trench), and the light-blocking unit SH having a thickness L3. The thickness L3 of the light-blocking unit SH corresponds to a thickness between the top surface and the bottom surface of the light-blocking film 14 in the horizontal trench 12b. In this modification example, it is desirable that the widths and the thicknesses have a relationship of L2<L1≤L3. That is, it is desirable that the thickness L3 of the light-blocking unit SH be set to be equal to or larger than the width L1 of the first trench. The reason is as follows.

In order for the light-blocking unit SH to exhibit a light-blocking function, the light-blocking film 14 in the light-blocking unit SH needs to have a thickness of a lower limit value or more (hereinafter this lower limit value is represented by "L"). In addition, since the light-blocking film 14 in the light-blocking unit SH is embedded into the light-blocking unit SH via the first trench, in order for the thickness of the light-blocking film 14 in the light-blocking unit SH to be set to be equal to or larger than a lower limit value L, the width L1 of the first trench also needs to have a lower limit value L or larger (L1≥L). For example, when the light-blocking film 14 having a thickness L and the element separation insulating film 13 having a thickness L' are embedded into the first trench, the width L1 of the first trench needs to be L+L'. However, if the width L1 of the first trench is large, the layout efficiency of the integrated circuit decreases. Therefore, it is desirable that the width L1 of the first trench be a value close to lower limit value L (L1≈L). On the other hand, the thickness L3 of the light-blocking unit SH may be equal to a lower limit value L (L3=L) or may be larger than the lower limit value L (L3>L). For example, when L3>L, the thickness of the light-blocking film 14 in the light-blocking unit SH may be set to L, and the thickness of the cavity 43 in the light-blocking film SH may be set to L3-L. In this manner, since it is desirable that L1 be close to L and L3 may be equal to L or larger than L, it is desirable that the thickness L3 of the light-blocking unit SH be set to be equal to or larger than the width L1 of the first trench (L3≥L1).

Here, the width L1 of the first trench is larger than the width L2 of the second trench (L1>L2), but if the width L1 of the first trench is too large, there is a risk of the layout efficiency of the integrated circuit decreasing. Therefore, it is desirable that the width L1 of the first trench be set to, for example, three times the width L2 of the second trench or less (L1≤3×L2), and additionally, it is desirable that the width L1 be set to twice the width L2 of the second trench or less (L₁≤2×L2).

Fig. 7 shows cross-sectional views of a structure of a solid-state imaging device of a fourth modification example of the first embodiment. Fig. 7A shows a lateral cross section of one pixel 1 in Fig. 1. Fig. 7B shows a longitudinal cross section taken along the line C-C' shown in Fig. 7A.

The solid-state imaging device of this modification example includes the same components as the solid-state imaging device of the first embodiment, but the memory unit MEM and the transistor of this modification example are not arranged over the regions of two pixels 1 but within the region of one pixel 1. Here, RST, AMP, and SEL shown in Fig. 7A indicate the above reset transistor, amplifying transistor, and select transistor, respectively.

Fig. 8 shows cross-sectional views of a structure of a solid-state imaging device of a fifth modification example of the first embodiment. Fig. 8A shows a lateral cross section of one pixel 1 in Fig. 1. Fig. 8B shows a longitudinal cross section taken along the line C-C' shown in Fig. 8A.

The solid-state imaging device of this modification example includes the same components as the solid-state imaging device of the first embodiment or the fourth modification example, but the vertical trench 12a of this modification example extends from the back surface of the substrate 11 in the longitudinal direction (+Z direction) instead of the front surface of the substrate 11. In this manner, the vertical trench 12a may extend from the front surface of the substrate 11 or may extend from the back surface of the substrate 11.

As described above, the solid-state imaging device of the present embodiment includes the substrate 11 in which the trench 12 including a plurality of vertical trenches 12a and the horizontal trench 12b are provided, and these vertical trenches 12a include the first trench having a thick width L1 and including the light-blocking film 14, and the second trench having a narrow width L2 and not including the light-blocking film 14. Therefore, according to the present embodiment, when the first trench having a thick width L1 is limited to a part of the vertical trench 12a, it is possible to minimize a decrease in the layout efficiency of the solid-state imaging device due to the trench 12.

### (Second embodiment)

Fig. 9 shows cross-sectional views of a structure of a solid-state imaging device of a second embodiment. Like Fig. 2A, Fig. 9A shows a lateral cross section of the pixel array region 2 in Fig. 1. Fig. 9B shows a longitudinal cross section taken along the line D-D' shown in Fig. 9A. Fig. 9C shows a longitudinal cross section taken along the line E-E' shown in Fig. 9A.

The solid-state imaging device of the present embodiment includes the same components as the solid-state imaging device of the first embodiment, but each vertical trench 12a of the present embodiment includes the element separation insulating film 13 and the light-blocking film 14 provided between the element separation insulating films 13 as in the first trench of the first embodiment. Each vertical trench 12a of the present embodiment is an example of the fourth trench.

The solid-state imaging device of the present embodiment includes one or more contact plugs 44 formed on the light-blocking film 14 in the vertical trench 12a, one or more wirings 45 formed above the substrate 11, and an interlayer insulating film 46 formed on the substrate 11 in addition to the components of the solid-state imaging device of the first embodiment. The contact plug 44 is, for example, a metal plug. The wiring 45 is, for example, a metal wiring. The interlayer insulating film 46 is, for example, a silicon oxide film (SiO₂). Fig. 9B shows the contact plug 44 formed in the interlayer insulating film 46. Fig. 9C shows the wiring 45 formed above the substrate 11 with the interlayer insulating film 46 therebetween. Since the height of the bottom surface of the wiring 45 of the present embodiment is the same as or lower than the height of the top surface of the contact plug 44, when the wiring 45 extends to the position of the contact plug 44, the wiring 45 becomes contact with the contact plug 44. However, in the present embodiment, contact between the wiring 45 and the contact plug 44 is avoided by a method to be described below.

Here, the wiring 45 is not exactly included in the lateral cross section in Fig. 9A, and is arranged at a position higher than the lateral cross section in Fig. 9A (refer to Fig. 9C). However, in order to make the solid-state imaging device of the present embodiment easy to understand, the wiring 45 is drawn in Fig. 9A.

As shown in Fig. 9A, each vertical trench 12a of the present embodiment includes a first region C1 and a second region C2. The first region C1 and the second region C2 have the same width (for example, the width L1 of the first embodiment), and both include the element separation insulating film 13 and the light-blocking film 14. However, the contact plug 44 is provided on the light-blocking film 14 in the first region C1, and the contact plug 44 is not provided on the light-blocking film 14 in the second region C2. In the present embodiment, the first region C1 is positioned in the pixel 1 in the +Y direction in Fig. 9A, and the second region C2 is positioned in the pixel 1 in the -Y direction in Fig. 9A.

On the other hand, the wiring 45 of the present embodiment is provided above the light-blocking film 14 in the second region C2, but is not provided above the light-blocking film 14 in the first region C1. In Fig. 9A, the wiring 45 extends over the light-blocking film 14 in the second region C2 in the X direction, and intersects the light-blocking film 14 in the second region C2. Since the wiring 45 of the present embodiment is not provided above the first region C1, it is not in contact with the contact plug 44 on the first region C1, and thus it is electrically insulated from the contact plug 44 on the first region C1.

As described above, the solid-state imaging device of the present embodiment includes the contact plug 44 on the vertical trench 12a. In this case, when the wiring 45 is arranged above the vertical trench 12a, the wiring 45 may come into contact with the contact plug 44. When the wiring 45 comes into contact with the contact plug 44, the wiring 45 that should not be electrically connected to the light-blocking film 14 is electrically connected to the light-blocking film 14 via the contact plug 44. Therefore, when the contact plug 44 is arranged on the vertical trench 12a, there is a risk of the layout efficiency of the wiring 45 decreasing in order to avoid contact between the contact plug 44 and the wiring 45.

However, the contact plug 44 of the present embodiment is arranged only on the first region C1 of the vertical trench 12a. Therefore, if the wiring 45 is arranged above the second region C2 of the vertical trench 12a, it is possible to avoid contact between the contact plug 44 and the wiring 45. In this manner, according to the present embodiment, even if the contact plug 44 is arranged on the vertical trench 12a, it is possible to minimize a decrease in the layout efficiency of the wiring 45 arranged above the vertical trench 12a.

### (Third embodiment)

Fig. 10 shows cross-sectional views of a structure of a solid-state imaging device of a third embodiment. Like Fig. 2A, Fig. 10A shows a lateral cross section of the pixel array region 2 in Fig. 1. Fig. 10B shows a longitudinal cross section taken along the line B-B' shown in Fig. 10A. Fig. 10C shows a longitudinal cross section taken along the line F-F' shown in Fig. 10A.

The solid-state imaging device of the present embodiment includes the same components as the solid-state imaging device of the first embodiment, but each vertical trench 12a of the present embodiment includes a first part T1 having a thick width W1 and a second part T2 having a narrow width W2. Each vertical trench 12a of the present embodiment is an example of the third trench. In addition, the thick width W1 is an example of the third width, and the narrow width W2 is an example of the fourth width thinner than the third width.

In the present embodiment, the first part T1 includes the element separation insulating film 13 and the light-blocking film 14 provided between the element separation insulating films 13. On the other hand, the second part T2 includes the element separation insulating film 13 but does not include the light-blocking film 14. The element separation insulating film 13 in the first part T1 and the element separation insulating film 13 in the second part T2 function as an element separation unit that separates the pixels 1 from each other as in the element separation insulating film 13 in the first trench and the element separation insulating film 13 in the second trench of the first embodiment. Here, although the light-blocking film 14 is not the element separation insulating film 13, since the light-blocking film 14 in the first part T1 is provided between the element separation insulating films 13, the light-blocking film 14 in the first part T1 functions as an element separation unit together with the element separation insulating film 13. Therefore, the element separation unit in the first part T1 has a thick width W1, and the element separation unit in the second part T2 has a narrow width W2.

In this manner, the vertical trench 12a of the present embodiment includes the first part T1 having a thick width W1 and the second part T2 having a narrow width W2 for each vertical trench 12a instead of the first trench having a thick width L1 and the second trench having a narrow width L2. Thereby, the light-blocking film 14 can be formed in the horizontal trench 12b with the first part T1 having a thick width W1 therebetween. In addition, by increasing only the width of the first part T1 of the vertical trench 12a rather than the width of all parts of the vertical trench 12a, it is possible to minimize a decrease in layout efficiency of the integrated circuit due to the vertical trench 12a. In the present embodiment, since it is not necessary to use the second part T2 having a narrow width W2 for embedding the light-blocking film 14, as shown in Figs. 10A and 10B, the light-blocking film 14 is not formed in the second part T2 having a narrow width W2.

In the present embodiment, the ratio between the length of the first part T1 having a thick width W1 and the length of the second part T2 having a narrow width W2 may be set to any ratio. In addition, the first part T1 of the present embodiment may be arranged anywhere in each vertical trench 12a. In other words, the position of the first part T1 of the present embodiment in the Y direction may be anywhere. However, in Fig. 10A, the first part T1 of each vertical trench 12a is provided at the boundary part (here, on the line F-F') of the mirror layout of the gate electrode 15 of the transfer transistors TRZ, TRY, TRX, TRG, and OFG. Such arrangement of the first part T1 is preferable in consideration of symmetry. Here, the gate electrodes 15 of the transfer transistors TRZ, TRY, TRX, TRG, and OFG of the present embodiment are arranged in a mirror layout in units of half pixels in the X direction and arranged in a mirror layout in units of two pixels in the Y direction.

Fig. 11 shows cross-sectional views of an example of an overall structure of the solid-state imaging device of the third embodiment.

Fig. 11A shows a lateral cross section of the pixel array region 2 like Fig. 10A, but shows a region for about 8 pixels. Fig. 11B schematically shows the lateral cross section of Fig. 11A, and shows colors of the pixels 1 in Fig. 11A. R, G, B, and IR shown in Fig. 11B indicate the red, green, blue, and infrared light pixels 1, respectively. In Fig. 11B, the layout cycle of pixels with the same color in the X direction is for two pixels.

Figs. 11A and 11B show a plurality of (here, 8) first parts T1 arranged at the boundary part of the above mirror layout. These first parts T1 are periodically arranged at the boundary part of the mirror layout. Thus, the layout cycle of the first part T1 in the X direction, which is the same as the layout cycle of pixels with the same color in the X direction, is for two pixels. Specifically, at the boundary part in the +Y direction in Figs. 11A and 11B, one first part T1 is arranged for every two pixels, and at the boundary part in the -Y direction in Figs. 11A and 11B, three first parts T1 are arranged for every two pixels.

Such arrangement of the first part T1 has an advantage that properties of pixels with the same color can be matched. For example, in Fig. 11B, both the B pixel on the left side and the B pixel on the right side have the first part T1 at the upper right position of the B pixel. Thereby, it is possible to match the influence of the first part T1 on the B pixel on the left side and the influence of the first part T1 on the B pixel on the right side.

Fig. 12 shows cross-sectional views of another example of an overall structure of the solid-state imaging device of the third embodiment.

Fig. 12A shows a lateral cross section for about 8 pixels of the pixel array region 2 like Fig. 11A. Fig. 12B schematically shows the lateral cross section of Fig. 12A and shows colors of the pixels 1 in Fig. 12A. In Fig. 12B, like Fig. 11B, the layout cycle of pixels with the same color in the X direction is for two pixels.

Figs. 12A and 12B show a plurality of (here, 3) first parts T1 arranged at the boundary part of the above mirror layout. These first parts T1 are aperiodically arranged at the boundary part of the mirror layout. In this manner, the first part T1 may be aperiodically arranged.

Here, as shown in Figs. 12A and 12B, the solid-state imaging device of the present embodiment may include the vertical trench 12a including the first part T1 and the second part T2 and the vertical trench 12a including only the second part T2.

Fig. 13 shows cross-sectional views of a structure of a solid-state imaging device of a modification example of the third embodiment. Figs. 13A, 13B, and 13C show cross sections corresponding to Figs. 10A, 10B, and 10C, respectively.

The solid-state imaging device of this modification example includes the same components as the solid-state imaging device of the third embodiment, but the first part T1 of this modification example is arranged outside the pixel array region 2. According to this modification example, the vertical trench 12a in the pixel array region 2 can be formed to include only the second part T2 having a narrow width W2, and it is possible to improve the layout efficiency inside the pixel array region 2.

As described above, the solid-state imaging device of the present embodiment includes the substrate 11 in which the trench 12 including one or more vertical trenches 12a and the horizontal trench 12b is provided, and at least one of the vertical trenches 12a has a thick width W1, and includes the first part T1 including the light-blocking film 14 and the second part T2 having a narrow width W2 and not including the light-blocking film 14. Therefore, according to the present embodiment, when the first part T1 having a thick width W1 is limited to a part of the vertical trench 12a, it is possible to minimize a decrease in the layout efficiency of the solid-state imaging device due to the trench 12.

### (Fourth embodiment)

Fig. 14 is a plan view for illustrating a structure of a solid-state imaging device of a fourth embodiment.

In the present embodiment, the substrate 11 shown in Fig. 14 is applied to the solid-state imaging device of any of the first to third embodiments (including modification examples). The substrate 11 is a Si{111} substrate. Fig. 14 shows a Si{111} substrate in a wafer state.

In Fig. 14, the X direction and the Y direction are parallel to the front surface of the substrate 11, and the Z direction is perpendicular to the front surface of the substrate 11. Fig. 14 shows a state in which a plurality of <110> directions and a plurality of <112> directions in the substrate 11 are perpendicular to the Z direction.

Here, since the vertical trench 12a of the first to third embodiments extends in the Z direction and the Y direction, when the vertical trench 12a is formed in the substrate 11, etching of the substrate 11 proceeds from the front surface of the substrate 11 in the -Z direction. In addition, since the horizontal trench 12b of the first to third embodiments extends in the X direction and the Y direction, when the horizontal trench 12b is formed in the substrate 11, etching of the substrate 11 proceeds from the vertical trench 12a in the ±X direction (hereinafter simply referred to as an "X direction").

When the horizontal trench 12b is formed, since the long distance in the substrate 11 is etched in the X direction, it is desirable for the substrate 11 to be easily etched in the X direction, that is, for the etching rate in the X direction to be high. On the other hand, it is known that the etching rate of the Si{111} substrate in the <110> direction is high.

Here, in the present embodiment, it is desirable that the vertical trench 12a have a shape extending in the lateral direction orthogonal to the <110> direction of the substrate 11. That is, it is desirable that the Y direction, which is a direction in which the vertical trench 12a extends in the lateral direction (trench extension direction), be orthogonal to the <110> direction. Thereby, the X direction is parallel to the <110> direction, and the horizontal trench 12b can be easily formed in the substrate 11.

Here, the substrate 11 of the present embodiment can be applied to a solid-state imaging device of a fifth embodiment (including a modification example) to be described below. In this case, it is desirable that the Y direction, which is the trench extension direction, be orthogonal to the <110> direction.

Hereinafter, the above Si{111} substrate, the <110> direction, and the like will be supplemented.

The Si{111} substrate in the present disclosure is a substrate or wafer made of a silicon single crystal and having a crystal plane represented by {111} in the Miller index notation. The Si{111} substrate in the present disclosure also includes a substrate or a wafer whose crystal orientation is deviated by several degrees, for example, deviated by several degrees from the {111} plane in the nearest [110] direction. In addition, it also includes a substrate in which a silicon single crystal is grown on a part or the entire surface of these substrates or wafers by an epitaxial method or the like.

In addition, in the notation of the present disclosure, "the {111} plane" is a general term for the (111) plane, the (-111) plane, the (1-11) plane, the (11-1) plane, the (-1-11) plane, the (-11-1) plane, the (1-1-1) plane, and the (-1-1-1) plane which are crystal planes equivalent to each other in symmetry. Therefore, the description of the Si{111} substrate in the specification of the present disclosure may be replaced with, for example, the Si(1-11) substrate. Here, the bar sign for expressing the index in the negative direction for the Miller index is substituted with a negative sign.

In addition, "the <110> direction" in the description of the present disclosure is a general term for the [110] direction, the [101] direction, the [011] direction, the [-110] direction, the [1-10] direction, the [-101] direction, the [10-1] direction, the [0-11] direction, the [01-1] direction, the [-1-10] direction, the [-10-1] direction and the [0-1-1] direction which are crystal plane directions equivalent to each other in symmetry, and may be replaced with any of them. However, in the present disclosure, etching is performed in a direction orthogonal to the element forming surface and a direction orthogonal to the direction orthogonal to the element forming surface (that is, a direction parallel to the element forming surface).

Fig. 28 shows specific combinations of surfaces and orientations at which etching in the <110> direction is established in the {111} plane, which is a crystal plane of the Si{111} substrate in the present disclosure.

As shown in Fig. 28, there are 96 (=8×12) combinations of the {111} plane and the <110> direction. However, the <110> direction in the present disclosure is limited to a direction orthogonal to the {111} plane which is the element forming surface and a direction parallel to the element forming surface. That is, the combination of the element forming surface of the Si{111} substrate of the present disclosure and the orientation in which etching is performed on the Si{111} substrate is selected from any of the combinations indicated by ∘ in Fig. 28.

In addition, in the present embodiment, a case in which etching proceeds in the X-axis direction using the Si{111} substrate, but does not proceed in the Y-axis direction or the Z-axis direction is exemplified. However, the present disclosure is not limited thereto, and it is sufficient that there is an etching proceeding orientation in both the X-axis direction and the Y-axis direction or either the X-axis direction or the Y-axis direction.

When crystal anisotropic etching is performed on the Si substrate using an etching solution, for example, when etching is performed using an alkaline solution, etching proceeds according to the reaction between Si bonds and OH ions in the Si etching reaction with an alkaline solution. Therefore, it is known that, when there are more dangling bonds exposed to the front surface side, etching easily proceeds, and when there are more back bonds extending to the bulk side, etching does not easily proceed.

That is, the horizontal light-blocking unit has one or two Si back bonds, that is at least less than three, in a direction substantially horizontal to the front surface of the substrate, but has three Si back bonds in a direction substantially perpendicular to the front surface of the substrate. For example, when Fig. 29 is exemplified, the back bond represents a bond extending in a negative direction on the opposite side when the Si dangling bond side is in the positive direction with respect to the normal line of the Si{111} plane.

Fig. 29 shows an example of three back bonds at -19.47° to +19.47° with respect to the {111} plane. Specifically, when the photoelectric conversion unit, the horizontal light-blocking unit, and the charge holding unit are provided in the Si{111} substrate, the horizontal light-blocking unit includes a first surface that is orthogonal to the first direction and along the first crystal plane of the Si{111} substrate represented by a surface index {111} and a second surface that is inclined with respect to the first direction and along the second crystal plane of the Si{111} substrate represented by a surface index {111}.

For example, as shown in Fig. 30, the Si{111} substrate also includes a substrate in which the front surface of the substrate is processed so that it has an off angle with respect to the <112> direction. When the off angle is 19.47° or less, even in the case of the substrate having an off angle, the relationship in which the etching rate in the <110> direction, that is, the direction in which there is one Si back bond, is sufficiently higher than the etching rate in the <111> direction, that is, the direction in which there are three Si back bonds, is maintained. When the off angle increases, the number of steps increases, and the density of the micro step increases, and thus the off angle is preferably 5° or less. Here, in the example shown in Fig. 30, a case in which the front surface of the substrate has an off angle in the <112> direction is exemplified, but it does not matter if there is an off angle in the <110> direction, nor does the direction of the off angle matter. In addition, the Si plane orientation can be analyzed using an X-ray diffraction method, an electron beam diffraction method, an electron backscatter diffraction method or the like. Since the number of Si back bonds is determined by the Si crystal structure, the number of back bonds can also be analyzed by analyzing the Si plane orientation.

### (Fifth embodiment)

Fig. 15 shows cross-sectional views of a structure of a solid-state imaging device of the fifth embodiment.

Fig. 15A shows an example of the trench 12 provided in the substrate 11. The trench 12 includes the vertical trench 12a having a thick width L1 and the horizontal trench 12b connected to the vertical trench 12a. Both the vertical trench 12a and the horizontal trench 12b include the element separation insulating film 13 and the light-blocking film 14. The light-blocking film 14 in the horizontal trench 12b surrounds the cavity 43, and functions as the light-blocking unit SH having a thickness L3 together with the cavity 43. The thickness L3 of the light-blocking unit SH corresponds to the thickness between the top surface and the bottom surface of the light-blocking film 14 in the horizontal trench 12b. The trench 12 in Fig. 15A can be used, for example, as the trench 12 of the second embodiment. Fig. 15A additionally shows a film thickness F1 of the element separation insulating film 13, a film thickness F2 of the light-blocking film 14, the size (depth) D1 of the vertical trench 12a in the Z direction, the size D2 of the horizontal trench 12b in the Z direction, and the size D3 in the X direction from the side surface of the vertical trench 12a to the side surface of the horizontal trench 12b.

The width L1 of the vertical trench 12a can be adjusted, for example, by controlling the width of the opening of the hardmask layer for forming the vertical trench 12a in the substrate 11. The size (depth) D1 of the vertical trench 12a in the Z direction can be adjusted, for example, by controlling the etching amount of the substrate 11 when the vertical trench 12a is formed in the substrate 11. The size D2 of the horizontal trench 12b in the Z direction can be adjusted, for example, by controlling the etchback amount of the substrate 11 when the horizontal trench 12b is formed in the substrate 11. The size D3 of the horizontal trench 12b in the X direction can be adjusted, for example, by controlling the alkaline etching time of the substrate 11 when the horizontal trench 12b is formed in the substrate 11. The size D3 of the horizontal trench 12b in the X direction may be adjusted, for example, by controlling the position of the etching stopper formed, which is arranged to form the horizontal trench 12b in the substrate 11. Details of these controls will be described below. The thickness L3 of the light-blocking unit SH can be adjusted according to these controls.

As described with reference to Fig. 6C, it is desirable that the thickness L3 of the light-blocking unit SH be set to be equal to or larger than the width L1 of the vertical trench 12a (L3≥L1). In this case, it is conceivable that the width L1 of the vertical trench 12a and the thickness of the light-blocking film 14 in the light-blocking unit SH are set to, for example, values close to the lower limit value L for the light-blocking unit SH to exhibit a light-blocking function. Thereby, it is possible to improve the layout efficiency of the integrated circuit and the light-blocking unit SH can exhibit a light-blocking function. Here, it should be noted that the thickness of the light-blocking film 14 in the light-blocking unit SH is twice that of the above film thickness F2. The reason is that the light-blocking unit SH includes the light-blocking film 14 having a film thickness F2 on both the upper side and the lower side of the cavity 43. For example, when the film thickness F2 of the light-blocking film 14 is 50 nm, the thickness of the light-blocking film 14 in the light-blocking unit SH is 100 nm. In order for the light-blocking unit SH to exhibit a light-blocking function, the thickness of 100 nm needs to be a lower limit value L or more. In this case, it is desirable that the thickness (for example, 100 nm) of the light-blocking film 14 in the light-blocking unit SH be set to a value close to the lower limit value L. Here, depending on conditions for forming the light-blocking film 14, the thickness of the light-blocking film 14 in the light-blocking unit SH may deviate from twice the film thickness F2, but even in that case, it is desirable that the thickness L3 of the light-blocking unit SH be set to be equal to or larger than the width L1 of the vertical trench 12a (L3≥L1).

Fig. 15B shows another example of the trench 12 provided in the substrate 11. The trench 12 includes the vertical trench 12a having a thick width L1 (the first trench), the vertical trench 12a having a narrow width L2 (the second trench), and the horizontal trench 12b connected to these vertical trenches 12a. The former vertical trench 12a and horizontal trench 12b include the element separation insulating film 13 and the light-blocking film 14, but the latter vertical trench 12a includes the element separation insulating film 13 and does not include the light-blocking film 14. The light-blocking film 14 in the horizontal trench 12b surrounds the cavity 43, and functions as the light-blocking unit SH having a thickness L3 together with the cavity 43. The trench 12 in Fig. 15B can be used as, for example, the trench 12 of the first embodiment. Fig. 15B additionally shows the film thickness F1 of the element separation insulating film 13, the film thickness F2 of the light-blocking film 14, the size (depth) D1 of the vertical trench 12a in the Z direction, the size D2 of the horizontal trench 12b in the Z direction, and the size D3 in the X direction from the side surface of any vertical trench 12a (here, the first trench) to the side surface of the horizontal trench 12b.

The width L1 and the sizes D1, D2, and D3 can be adjusted in the same manner as in the case of Fig. 15A. In addition, the width L2 can be adjusted in the same manner as in the width L1. The thickness L3 of the light-blocking unit SH can be adjusted according to these adjustments. As in the case of Fig. 15A, it is desirable that the thickness L3 of the light-blocking unit SH be set to be equal to or larger than the width L1 of the vertical trench 12a (the first trench) (L3≥L1). In this case, it is conceivable that the width L1 of the vertical trench 12a and the thickness of the light-blocking film 14 in the light-blocking unit SH are set to, for example, a value close to the lower limit value L for the light-blocking unit SH to exhibit a light-blocking function. Thereby, it is possible to improve the layout efficiency of the integrated circuit and the light-blocking unit SH can exhibit a light-blocking function.

Figs. 16 to 18 show cross-sectional views illustrating a method of producing the solid-state imaging device of the fifth embodiment. In this method, the substrate 11 is processed into the structure in Fig. 15B. Here, when this method is applied to the structure in Fig. 15A, processing related to the vertical trench 12a having a narrow width L2 (the second trench) may be omitted.

First, a hardmask layer 47 is formed on the substrate 11 (Fig. 16A). The hardmask layer 47 is, for example, a silicon oxide film (SiO₂). Next, an opening is formed in the hardmask layer 47 by lithography and etching, and the opening is transferred to the substrate 11 by etching (Fig. 16B). As a result, the vertical trench 12a (the first trench and the second trench) is formed in the substrate 11. Here, the above widths L1 and L2 can be adjusted by controlling the width of the opening of the hardmask layer 47. In addition, the above size D1 can be adjusted, for example, by controlling the etching amount of the substrate 11 in the process in Fig. 16B. In this method, for example, the width L1 of the first trench is set to about 200 nm, and the width L2 of the second trench is set to 100 nm or less.

Next, a side wall film 48 is formed on the side surface of the vertical trench 12a (Fig. 16C). The side wall film 48 is, for example, a silicon oxide film (SiO₂). Next, the substrate 11 in the vicinity of the bottom of the vertical trench 12a is anisotropically processed by etchback (Fig. 17A). Next, the substrate 11 in the vicinity of the bottom of the vertical trench 12a is isotropically processed by alkaline etching (Fig. 17B). As a result, a horizontal trench 11b is formed in the substrate 11. Here, the above size D2 can be adjusted by controlling the etchback amount of the substrate 11 in the process in Fig. 17A. In addition, the above size D3 can be adjusted by controlling the alkaline etching time of the substrate 11 in the process in Fig. 17B.

Here, the substrate 11 of the present embodiment is desirably the Si{111} substrate described in the fourth embodiment. Thereby, it is possible to increase the etching rate of the substrate 11 in the X direction and it is possible to easily form the horizontal trench 11b in the process in Fig. 17B.

Next, the hardmask layer 47 and the side wall film 48 are removed from the top surface and the side surface of the substrate 11 (Fig. 17C). Fig. 17C shows the substrate 11 in which the trench 12 including the vertical trench 12a and the horizontal trench 12b is formed.

Next, the element separation insulating film 13 is formed on the entire surface of the substrate 11 (Fig. 18A). As a result, the element separation insulating film 13 is formed on the side surface of the vertical trench 12a and the side surface, the top surface, and the bottom surface of the horizontal trench 12b. Here, it should be noted that, while the first trench is not completely filled with the element separation insulating film 13, the second trench is completely filled with the element separation insulating film 13.

Next, the light-blocking film 14 is formed on the entire surface of the substrate 11 (Fig. 18B). As a result, the light-blocking film 14 is formed on the side surface of the vertical trench 12a (the first trench) and the side surface, the top surface, and the bottom surface of the horizontal trench 12b with the element separation insulating film 13 therebetween. Here, it should be noted that, while the first trench is completely filled with the element separation insulating film 13 and the light-blocking film 14, the cavity 43 remains in the horizontal trench 12b.

Next, the element separation insulating film 13 and the light-blocking film 14 outside the trench 12 are removed by chemical mechanical polishing (CMP) (Fig. 18C). In this manner, in the trench 12, the element separation unit and the light-blocking unit SH are formed. In this method, for example, the thickness L3 of the light-blocking unit SH is set to about 1 µm.

Here, in this method, the thickness L3 of the light-blocking unit SH is set to be equal to or larger than the width L1 of the first trench (L3≥L1). Such a structure can be realized, for example, by increasing the etchback amount of the substrate 11 in the process in Fig. 17A and increasing the size D2. This is because, as the size D2 increases, the thickness L3 of the light-blocking unit SH also becomes thicker. In addition, when the alkaline etching time of the substrate 11 in the process in Fig. 17B becomes longer, since the horizontal trench 12b expands not only in the X direction but also expands slightly in the Z direction, the size D2 can increase, and thus the thickness L3 of the light-blocking unit SH can also increase.

Figs. 19 to 21 show cross-sectional views of details of a method of producing the solid-state imaging device of the fifth embodiment. In this method, the solid-state imaging device shown in Fig. 2 is produced. Figs. 19, 20, and 21A show the above A-A' cross section, and Figs. 19, 20, and 21B show the above B-B' cross section.

First, in the substrate 11, the N-type semiconductor region 21, the P+type semiconductor region 22, and the P-type semiconductor region 23 are formed (Figs. 19A and 19B). These impurity semiconductor regions are formed by, for example, ion implantation.

Next, in the substrate 11, the trench 12 including the vertical trench 12a and the horizontal trench 12b is formed, and in the trench 12, the element separation insulating film 13 and the light-blocking film 14 are formed (Figs. 20A and 20B). These trenches 12, the element separation insulating film 13, and the light-blocking film 14 are formed by, for example, methods shown in Figs. 16 to 18.

Next, in the P-type semiconductor region 23 in the substrate 11, the N+type semiconductor region 24, the N+type semiconductor region 25, and the N+type semiconductor region 26 are formed, and on the substrate 11 and in the substrate 11, the gate electrode 15 is formed (Figs. 21A and 21B). In this manner, the solid-state imaging device shown in Fig. 2 is produced.

Hereinafter, various modification examples of the fifth embodiment will be described.

Figs. 22 to 24 show cross-sectional views of structures of solid-state imaging devices of first to sixth modification examples of the fifth embodiment.

Fig. 22A shows a solid-state imaging device of the first modification example. The solid-state imaging device of this modification example includes the same components as the solid-state imaging device in Fig. 3, but transistors such as TRX, components in the laminated part 34, the memory unit MEM and the like are not shown. The reference numeral 49 in Fig. 22A indicates a light-blocking film formed between the back surface of the substrate 11 and the flattening layer 31. As in the light-blocking film 14, the light-blocking film 49 is, for example, a metal layer such as a tungsten (W) layer or a compound semiconductor layer having a chalcopyrite structure having a high absorption coefficient.

As shown in Fig. 22A, the trench 12 of this modification example includes the vertical trench 12a including the element separation insulating film 13 and the light-blocking film 14, and the horizontal trench 12b including the element separation insulating film 13, the light-blocking film 14, and the cavity 43. In this modification example, the vertical trench 12a extends from the front surface of the substrate 11 in the longitudinal direction, and the horizontal trench 12b extends from the vertical trench 12a in the lateral direction. The trench 12 of this modification example does not include the vertical trench 12a including only the element separation insulating film 13, and has the same structure as the trench 12 in Fig. 15A.

Fig. 22B shows a solid-state imaging device of the second modification example. The solid-state imaging device of this modification example includes the same components as the solid-state imaging device of the first modification example, but the trench 12 of this modification example includes the vertical trench 12a extending from the front surface of the substrate 11 in the longitudinal direction, the vertical trench 12a extending from the back surface of the substrate 11 in the longitudinal direction, and the horizontal trench 12b extending from these vertical trenches 12a in the lateral direction. In this manner, the vertical trench 12a may extend from the front surface of the substrate 11 or may extend from the back surface of the substrate 11. According to this modification example, when the light-blocking film 14 is simultaneously embedded into the horizontal trench 12b from the front surface and the back surface of the substrate 11, the light-blocking film 14 can be embedded into the horizontal trench 12b in a short time.

Fig. 23A shows a solid-state imaging device of the third modification example. The solid-state imaging device of this modification example includes the same components as the solid-state imaging device of the first modification example, but the trench 12 of this modification example includes the thick vertical trench 12a (the first trench) extending from the front surface of the substrate 11 in the longitudinal direction, the thin vertical trench 12a (the second trench) extending from the front surface of the substrate 11 in the longitudinal direction, and the horizontal trench 12b extending from these vertical trenches 12a in the lateral direction. The trench 12 of this modification example includes the first trench and the second trench, and has the same structure as the trench 12 in Fig. 15B. According to this modification example, when the substrate 11 is etched simultaneously from the first trench and the second trench to form the horizontal trench 12b, the horizontal trench 12b can be formed in a short time.

Fig. 23B shows a solid-state imaging device of the fourth modification example. The solid-state imaging device of this modification example includes the same components as the solid-state imaging device of the first modification example, but the trench 12 of this modification example includes the vertical trench 12a (the first and second trenches) extending from the front surface of the substrate 11 in the longitudinal direction, the vertical trench 12a extending from the back surface of the substrate 11 in the longitudinal direction, and the horizontal trench 12b extending from these vertical trenches 12a in the lateral direction. The trench 12 of this modification example has a structure in which the trench 12 of the second modification example and the trench 12 of the third modification example are combined, and the same effects as those of these modification examples can be enjoyed.

Fig. 24A shows a solid-state imaging device of the fifth modification example. The trench 12 of this modification example has a structure similar to that of the trench 12 of the second modification example. However, in this modification example, the vertical trench 12a on the front surface side of the substrate 11 is a thin trench and includes the element separation insulating film 13, but does not include the light-blocking film 14. Therefore, according to this modification example, it is possible to improve the layout efficiency on the front surface side of the substrate 11. In this modification example, the light-blocking film 14 can be embedded into the horizontal trench 12b using the vertical trench 12a on the back surface side of the substrate 11.

Fig. 24B shows a solid-state imaging device of the sixth modification example. The trench 12 of this modification example has a structure similar to that of the trench 12 of the fifth modification example. However, in this modification example, the width of the vertical trench 12a on the back surface side of the substrate 11 is set to be thicker than that of the fifth embodiment. Therefore, in this modification example, the light-blocking film 14 is embedded into the horizontal trench 12b until the cavity 43 disappears from the horizontal trench 12b. It should be noted that, since the thick vertical trench 12a of this modification example is arranged on the back surface side of the substrate 11, the layout efficiency on the front surface side of the substrate 11 does not increase.

As described above, according to the present embodiment, the horizontal trench 12b and the light-blocking unit SH can be formed using various vertical trenches 12a. For example, the horizontal trench 12b and the light-blocking unit SH of the present embodiment can be formed using the vertical trench 12a on the front surface side of the substrate 11, the vertical trench 12a on the back surface side of the substrate 11, the vertical trench 12a having a thick width L1, the vertical trench 12a having a narrow width L2 or the like. Thereby, it is possible to form the horizontal trench 12b and the light-blocking unit SH in a short time, and it is possible to improve the layout efficiency of the solid-state imaging device. For example, when the first trench and the light-blocking unit SH are formed so that the condition of L3≥L1 is satisfied, the width L1 of the first trench and the film thickness F2 of the light-blocking film 14 can be made as small as possible, and the thickness of the light-blocking film 14 in the light-blocking unit SH can be set to a thickness at which the light-blocking function can be exhibited.

Here, the structure of the solid-state imaging device of the present embodiment and the method of producing the same can also be applied to the solid-state imaging device of the third embodiment. In this case, "width L1", "width L2", "first trench", and "second trench" in the above description may be replaced with "width W1", "width W2", "first part T1", "second part T2".

### (Application examples)

Fig. 25 is a block diagram showing a configuration example of an electronic device. The electrical device shown in Fig. 25 is a camera 100.

The camera 100 includes an optical unit 101 including a lens group and the like, the imaging device 102 which is a solid-state imaging device of any of the first to fifth embodiments (including modification examples), a digital signal processor (DSP) circuit 103 which is a camera signal processing circuit, a frame memory 104, a display unit 105, a recording unit 106, an operation unit 107, and a power supply unit 108. In addition, the DSP circuit 103, the frame memory 104, the display unit 105, the recording unit 106, the operation unit 107, and the power supply unit 108 are connected to each other via a bus line 109.

The optical unit 101 captures incident light (image light) from a subject and forms an image on an image forming surface of the imaging device 102. The imaging device 102 converts a light intensity of the incident light imaged on the image forming surface by the optical unit 101 into an electrical signal in pixel units and outputs it as a pixel signal.

The DSP circuit 103 performs signal processing on the pixel signal output by the imaging device 102. The frame memory 104 is a memory for storing one screen of a moving image or still image captured by the imaging device 102.

The display unit 105 includes, for example, a panel type display device such as a liquid crystal panel or an organic EL panel, and displays the moving image or the still image captured by the imaging device 102. The recording unit 106 records the moving image or the still image captured by the imaging device 102 in a recording medium such as a hard disk or a semiconductor memory.

The operation unit 107 issues operation commands for various functions of the camera 100 under the operation of the user. The power supply unit 108 appropriately supplies various power supplies that serve as operation power supplies for the DSP circuit 103, the frame memory 104, the display unit 105, the recording unit 106, and the operation unit 107 to these supply targets.

Acquisition of a favorable image can be expected by using a solid-state imaging device of any of the first to fifth embodiments as the imaging device 102.

The solid-state imaging device can be applied to various other products. For example, the solid-state imaging device may be mounted in various moving objects such as automobiles, electric vehicles, hybrid electric vehicles, motorcycles, bicycles, personal mobilities, airplanes, drones, ships, and robots.

Fig. 26 is a block diagram showing a configuration example of a mobile control system. The mobile control system shown in Fig. 26 is a vehicle control system 200.

The vehicle control system 200 includes a plurality of electronic control units connected via a communication network 201. In the examples shown in Fig. 26, the vehicle control system 200 includes a drive system control unit 210, a body system control unit 220, an outside-vehicle information detection unit 230, an in-vehicle information detection unit 240, and an integrated control unit 250. Fig. 26 additionally shows a microcomputer 251, an audio image output unit 252, and an in-vehicle network interface (I/F) 253 as components of the integrated control unit 250.

The drive system control unit 210 controls the operation of the device related to the drive system of the vehicle according to various programs. For example, the drive system control unit 210 functions as a control device such as a driving force generating device for generating a driving force of a vehicle such as an internal combustion engine or a drive motor, a driving force transmission mechanism for transmitting a driving force to wheels, a steering mechanism for adjusting a steering angle of a vehicle, and a braking device for generating a braking force of a vehicle.

The body system control unit 220 controls operations of various devices mounted in a vehicle body according to various programs. For example, the body system control unit 220 functions as a control device such as a smart key system, a keyless entry system, a power window device, various lamps (for example, a headlamp, a back lamp, a brake lamp, a turn signal, and a fog lamp). In this case, radio waves transmitted from a portable device that substitutes for a key or signals of various switches may be input to the body system control unit 220. The body system control unit 220 receives such a radio wave or signal input and controls a door lock device, a power window device, and a lamp of the vehicle.

The outside-vehicle information detection unit 230 detects information outside the vehicle in which the vehicle control system 200 is mounted. For example, an imaging unit 231 is connected to the outside-vehicle information detection unit 230. The outside-vehicle information detection unit 230 causes the imaging unit 231 to capture an image of the outside of the vehicle and receives the captured image from the imaging unit 231. The outside-vehicle information detection unit 230 may perform object detection processing or distance detection processing for peoples, cars, obstacles, signs, and letters on the road based on the received image.

The imaging unit 231 is an optical sensor that receives light and outputs an electrical signal according to the intensity of the light received. The imaging unit 231 can output an electrical signal as an image or output it as a distance measurement information. The light received by the imaging unit 231 may be visible light or invisible light such as infrared rays. The imaging unit 231 includes the solid-state imaging device of any of the first to fifth embodiments.

The in-vehicle information detection unit 240 detects information inside the vehicle in which the vehicle control system 200 is mounted. For example, a driver status detection unit 241 that detects the driver's status is connected to the in-vehicle information detection unit 240. For example, the driver status detection unit 241 includes a camera that images the driver, and the in-vehicle information detection unit 240 may calculate the degree of fatigue or degree of concentration of the driver based on the detection information input from the driver status detection unit 241, and may determine whether the driver is asleep. The camera may include a solid-state imaging device of any of the first to fifth embodiments, and may be, for example, the camera 100 shown in Fig. 25.

The microcomputer 251 can calculate a control target value of the driving force generating device, the steering mechanism, or the braking device based on information inside and outside the vehicle acquired by the outside-vehicle information detection unit 230 or the in-vehicle information detection unit 240, and output a control command to the drive system control unit 210. For example, the microcomputer 251 can perform cooperative control in order to realize functions of an advanced driver assistance system (ADAS) such as following traveling, vehicle speed maintenance driving, collision warning, and lane deviation warning based on vehicle collision avoidance, impact mitigation, and inter-vehicle distance.

In addition, the microcomputer 251 can perform cooperative control for automatic driving in which autonomous driving is performed without the operation of the driver by controlling the driving force generating device, the steering mechanism or the braking device based on information around the vehicle acquired by the outside-vehicle information detection unit 230 or the in-vehicle information detection unit 240.

In addition, the microcomputer 251 can output a control command to the body system control unit 220 based on the information outside the vehicle acquired by the outside-vehicle information detection unit 230. For example, the microcomputer 251 can perform cooperative control for antiglare such as switching a high beam to a low beam by controlling a headlamp according to a position of a preceding vehicle or an oncoming vehicle detected by the outside-vehicle information detection unit 230.

The audio image output unit 252 transmits an output signal of at least one of audio and an image to an output device that can visually or audibly notify the passenger of the vehicle or the outside of information. In the example shown in Fig. 26, as such an output device, an audio speaker 261, a display unit 262, and an instrument panel 263 are shown. The display unit 262 may include, for example, an onboard display or a head-up display.

Fig. 27 is a plan view showing a specific example of setting positions of the imaging unit 231 in Fig. 26.

A vehicle 300 shown in Fig. 27 includes imaging units 301, 302, 303, 304, and 305 as the imaging unit 231. The imaging units 301, 302, 303, 304, and 305 are provided at positions, for example, the front nose, side mirrors, rear bumpers, back doors, and the upper part of the windshield in the cabin of the vehicle 300.

The imaging unit 301 provided in the front nose mainly acquires an image of the front of the vehicle 300. The imaging unit 302 provided in the left side mirror and the imaging unit 303 provided in the right side mirror mainly acquire an image of the side of the vehicle 300. The imaging unit 304 provided in the rear bumper or the back door mainly acquires an image of the rear of the vehicle 300. The imaging unit 305 provided in the upper part of the windshield in the cabin mainly acquires an image to the front of the vehicle 300. The imaging unit 305 is used for detecting, for example, preceding vehicles, pedestrians, obstacles, traffic lights, traffic signs, and lanes.

Fig. 27 shows an example of imaging ranges of the imaging units 301, 302, 303, and 304 (hereinafter referred to as "imaging units 301 to 304"). An imaging range 311 indicates an imaging range of the imaging unit 301 provided in the front nose. An imaging range 312 indicates an imaging range of the imaging unit 302 provided in the left side mirror. An imaging range 313 indicates an imaging range of the imaging unit 303 provided in the right side mirror. An imaging range 314 indicates an imaging range of the imaging unit 304 provided in the rear bumper or the back door. For example, a bird's-eye view image of the vehicle 300 from above can be obtained by superimposing image data captured by the imaging units 301 to 304. Hereinafter, the imaging ranges 311, 312, 313, and 314 will be referred to as "imaging ranges 311 to 314".

At least one of the imaging units 301 to 304 may have a function of acquiring distance information. For example, at least one of the imaging units 301 to 304 may be a stereo camera including a plurality of imaging devices or an imaging device having pixels for phase difference detection.

For example, the microcomputer 251 (Fig. 26) calculates a distance to each three-dimensional object in the imaging ranges 311 to 314 and a change in the distance over time (a relative speed with respect to the vehicle 300) based on the distance information obtained from the imaging units 301 to 304. The microcomputer 251 can extract, based on these calculation results, a three-dimensional object that travels at a predetermined speed (for example, 0 km/h or more) in almost the same direction as the vehicle 300, which is the closest three-dimensional object on the traveling path of the vehicle 300, as a preceding vehicle. In addition, the microcomputer 251 can set an inter-vehicle distance to be secured in advance in front of the preceding vehicle and perform automatic brake control (including following stop control), automatic acceleration control (including following start control) and the like. In this manner, according to this example, it is possible to perform cooperative control for automatic driving in which autonomous driving is performed without the operation of the driver.

For example, based on the distance information obtained from the imaging units 301 to 304, the microcomputer 251 classifies the three-dimensional object data related to the three-dimensional object as a two-wheeled vehicle, an ordinary vehicle, a large vehicle, a pedestrian, a utility pole, or another three-dimensional object and performs extraction, and can use the result for automatic avoidance of an obstacle. For example, the microcomputer 251 distinguishes obstacles around the vehicle 300 as obstacles that the driver of the vehicle 300 can visually recognize and obstacles that are difficult for the driver to visually recognize. Then, the microcomputer 251 determines a collision risk indicating the degree of risk of collision with each obstacle, and when the collision risk is equal to or higher than the set value and there is a possibility of collision, an alarm is output to the driver through the audio speaker 261 and the display unit 262, forced deceleration and avoidance steering are performed through the drive system control unit 210, and thus it is possible to perform driving support for collision avoidance.

At least one of the imaging units 301 to 304 may be an infrared camera that detects infrared rays. For example, the microcomputer 251 can recognize a pedestrian by determining whether there is a pedestrian in the captured images of the imaging units 301 to 304. Such pedestrian recognition is performed by, for example, a procedure in which feature points in the captured images of the imaging units 301 to 304 as infrared cameras are extracted and a procedure in which pattern matching processing is performed on a series of feature points indicating the outline of the object and it is determined whether the object is a pedestrian. When the microcomputer 251 determines that there is a pedestrian in the captured images of the imaging units 301 to 304 and the pedestrian is recognized, the audio image output unit 252 controls the display unit 262 so that the recognized pedestrian is superimposed and displayed with a square contour line for emphasis. In addition, the audio image output unit 252 may control the display unit 262 so that an icon indicating a pedestrian or the like is displayed at a desired position.

While embodiments of the present disclosure have been described above, these embodiments may be implemented with various modifications without departing from the spirit of the present disclosure. For example, a combination of two or more embodiments may be implemented.

### [Reference Signs List]

- 1: Pixel
- 2: Pixel array region
- 3: Control circuit
- 4: Vertical drive circuit
- 5: Column signal processing circuit
- 6: Horizontal drive circuit
- 7: Output circuit
- 8: Vertical signal line
- 9: Horizontal signal line
- 11: Substrate
- 12: Trench
- 12a: Vertical trench
- 12b: Horizontal trench
- 13: Element separation insulating film
- 14: Light-blocking film
- 15: Gate electrode
- 16: Trench
- 16a: Vertical trench
- 17: Element separation insulating film
- 21: N-type semiconductor region
- 22: P+type semiconductor region
- 23: P-type semiconductor region
- 24: N+type semiconductor region
- 25: N+type semiconductor region
- 26: N+type semiconductor region
- 31: Flattening layer
- 32: Color filter layer
- 33: On-chip lens
- 34: Laminated part
- 35: Metal plug
- 36: Wiring layer
- 37: Metal pad
- 41: Cavity
- 42: Fixed charge film
- 43: Cavity
- 44: Contact plug
- 45: Wiring
- 46: Interlayer insulating film
- 47: Hardmask layer
- 48: Side wall film
- 49: Light-blocking film

## Claims

1. A solid-state imaging device (102), comprising:
a substrate (11) including one or more vertical trenches (12a) extending in a longitudinal direction and a horizontal trench (12b) that extends in a lateral direction and is connected to the one or more vertical trenches (12a),
wherein the horizontal trench (12b) is provided between a photoelectric conversion unit (PD) and a charge holding unit (MEM) in the substrate (11) and includes a light-blocking film (14), and
wherein the one or more vertical trenches (12a) include
a first trench (12a) having a first width (L1) and including the light-blocking film (14), and
a second trench (12a) having a second width (L2) narrower than the first width (L1) and not including the light-blocking film (14), or
a third trench (12a) including a first part (T1) having a third width (W1) and including the light-blocking film (14) and a second part (T2) having a fourth width (W2) narrower than the third width (W1) and not including the light-blocking film (14).

2. The solid-state imaging device (102) according to claim 1,
wherein the first trench (12a) includes an element separation insulating film (13, 17) and the light-blocking film (14), and
wherein the second trench (12a) includes the element separation insulating film (13) and does not include the light-blocking film (14).

3. The solid-state imaging device (102) according to claim 1,
wherein the light-blocking film (14) is provided between fixed charge films (42) in the horizontal trench (12b).

4. The solid-state imaging device (102) according to claim 1,
wherein the horizontal trench (12b) includes the light-blocking film (14) and a cavity (43) provided between the light-blocking films (14); or
wherein the thickness (L3) between a top surface and a bottom surface of the light-blocking film (14) in the horizontal trench (12b) is equal to or larger than the first width (L1) of the first trench (12a).

5. The solid-state imaging device (102) according to claim 1, further comprising one or more electrodes (15) that are provided on the substrate and overlap on the second trench; or
wherein the first part (T1) includes an element separation insulating film (13, 17) and the light-blocking film (14), and
wherein the second part (T2) includes the element separation insulating film (13, 17) and does not include the light-blocking film (14).

6. The solid-state imaging device (102) according to claim 1,
wherein the first part (T1) is provided at a boundary part of a mirror layout of one or more electrodes provided on the substrate.

7. The solid-state imaging device (102) according to claim 6,
wherein the substrate (11) periodically includes the plurality of first parts (T1) at the boundary part, and
wherein a layout cycle of the first part (T1) is the same as a layout cycle of pixels (1) with the same color in the substrate (11).

8. The solid-state imaging device according to claim 1,
wherein the first part (T1) is provided outside a pixel array region (2).

9. The solid-state imaging device (102) according to claim 1,
wherein the substrate (11) is a silicon {111} substrate, and
wherein the one or more vertical trenches (12a) extend in a lateral direction orthogonal to the <110> direction; or
wherein the one or more vertical trenches (12a) include both a trench (12a) extending from a front surface of the substrate in a longitudinal direction and a trench (12a) extending from a back surface of the substrate in the longitudinal direction.

10. A solid-state imaging device (102), comprising:
a substrate (11) including one or more vertical trenches (12a) extending in a longitudinal direction and a horizontal trench (12b) that extends in a lateral direction and is connected to the one or more vertical trenches (12a),
wherein the horizontal trench (12b) is provided between a photoelectric conversion unit (PD) and a charge holding unit (MEM) in the substrate (11) and includes a light-blocking film (14), and
wherein the one or more vertical trenches (12a) include
a fourth trench (12a) including a first region (C1) in which a plug (44) is provided on the light-blocking film (14) in the first region (C1), which is a first region (C1) including the light-blocking film (14), and a second region (C2) in which no plug (44) is provided on the light-blocking film (14) in the second region (C2), which is a second region (C2) including the light-blocking film (14), and
the solid-state imaging device (102) further comprising
a wiring (45) that is provided above the light-blocking film (14) in the second region (C2) and electrically insulated from the plug (44) on the light-blocking film (14) in the first region (C1).

11. The solid-state imaging device (102) according to claim 10,
wherein each of the first region (C1) and the second region (C2) includes an element separation insulating film (13) and the light-blocking film (14).

12. The solid-state imaging device (102) according to claim 10,
wherein the first region (C1) and the second region (C2) have the same width (L1); or wherein the substrate is a silicon {111} substrate, and
wherein the one or more vertical trenches (12a) extend in a lateral direction orthogonal to the <110> direction.

13. A solid-state imaging device (102), comprising:
a substrate (11) including one or more vertical trenches (12a) extending in a longitudinal direction and a horizontal trench (12b) that extends in a lateral direction and is connected to the one or more vertical trenches (12a),
wherein the horizontal trench (12b) is provided between a photoelectric conversion unit (PD) and a charge holding unit (MEM) in the substrate (11) and includes a light-blocking film (14),
wherein the one or more vertical trenches (12a) include a first trench (12a) having a first width (L1) and including the light-blocking film (12a), and
wherein the thickness (L3) between a top surface and a bottom surface of the light-blocking film (14) in the horizontal trench (12b) is equal to or larger than the first width (L1) of the first trench (12a), wherein the one or more vertical trenches (12a) include both a trench (12a) extending from a front surface of the substrate (11) in a longitudinal direction and a trench (12a) extending from a back surface of the substrate (11) in the longitudinal direction, and
wherein the one or more vertical trenches (12a) further include a second trench (12a) having a second width (L2) narrower than the first width (L1) and not including the light-blocking film (14), and
wherein each of the trench (12a) extending from a front surface of the substrate (11) in a longitudinal direction and the trench (12a) extending from a back surface of the substrate (11) in the longitudinal direction is either the first trench (12a) or the second trench (12a).

14. The solid-state imaging device (102) according to claim 13,
wherein the horizontal trench (12b) includes the light-blocking film (14) and a cavity (43) provided between the light-blocking films (14).

15. A method of producing a solid-state imaging device (102) as recited in claim 1, comprising:
forming one or more vertical trenches (12a) extending in a longitudinal direction in a substrate (11);
forming a horizontal trench (12b) that extends in a lateral direction in the substrate (11) and is connected to the one or more vertical trenches (12a); and
forming a light-blocking film (14) in the horizontal trench (12a),
wherein the one or more vertical trenches (12a) are formed to include a first trench (12a) having a first width (L1) and including the light-blocking film (14), and
a second trench (12a) having a second width (L2) narrower than the first width (L1) and not including the light-blocking film (14), or
a third trench (12a) including a first part (T1) having a third width (W1) and including the light-blocking film (14) and a second part (T2) having a fourth width (W2) narrower than the third width (W1) and not including the light-blocking film (14).

## Patentansprüche

1. Festkörperbildgebungsvorrichtung (102), umfassend:
ein Substrat (11), das einen oder mehrere vertikale Gräben (12a), die sich in einer Längsrichtung erstrecken, und einen horizontalen Graben (12b) einschließt, der sich in einer seitlichen Richtung erstreckt und mit dem einen oder den mehreren vertikalen Gräben (12a) verbunden ist,
wobei der horizontale Graben (12b) zwischen einer photoelektrischen Umwandlungseinheit (PD) und einer Ladungshalteeinheit (MEM) in dem Substrat (11) bereitgestellt ist und einen lichtblockierenden Film (14) einschließt, und
wobei der eine oder die mehreren vertikalen Gräben (12a) einschließen
einen ersten Graben (12a), der eine erste Breite (L1) aufweist und den lichtblockierenden Film (14) einschließt, und
einen zweiten Graben (12a), der eine zweite Breite (L2) aufweist, die schmaler als die erste Breite (L1) ist und den lichtblockierenden Film (14) nicht einschließt, oder
einen dritten Graben (12a), der einen ersten Teil (T1), der eine dritte Breite (W1) aufweist und den lichtblockierenden Film (14) einschließt, und einen zweiten Teil (T2) einschließt, der eine vierte Breite (W2) aufweist, die schmaler als die dritte Breite (W1) ist und den lichtblockierenden Film (14) nicht einschließt.

2. Festkörperbildgebungsvorrichtung (102) nach Anspruch 1,
wobei der erste Graben (12a) einen Elementtrennungsisolierfilm (13, 17) und den lichtblockierenden Film (14) einschließt, und
wobei der zweite Graben (12a) den Elementtrennungsisolierfilm (13) einschließt, aber nicht den lichtblockierenden Film (14) einschließt.

3. Festkörperbildgebungsvorrichtung (102) nach Anspruch 1,
wobei der lichtblockierende Film (14) zwischen fixierten Ladungsfilmen (42) in dem horizontalen Graben (12b) bereitgestellt ist.

4. Festkörperbildgebungsvorrichtung (102) nach Anspruch 1,
wobei der horizontale Graben (12b) den lichtblockierenden Film (14) und einen Hohlraum (43), der zwischen den lichtblockierenden Filmen (14) bereitgestellt ist, einschließt; oder
wobei die Dicke (L3) zwischen einer oberen Oberfläche und einer unteren Oberfläche des lichtblockierenden Films (14) in dem horizontalen Graben (12b) gleich oder größer als die erste Breite (L1) des ersten Grabens (12a) ist.

5. Festkörperbildgebungsvorrichtung (102) nach Anspruch 1, ferner umfassend eine oder mehrere Elektroden (15), die auf dem Substrat bereitgestellt sind und den zweiten Graben überlappen; oder
wobei der erste Teil (T1) einen Elementtrennungsisolierfilm (13, 17) und den lichtblockierenden Film (14) einschließt, und
wobei der zweite Teil (T2) den Elementtrennungsisolierfilm (13, 17) einschließt, aber nicht den lichtblockierenden Film (14) einschließt.

6. Festkörperbildgebungsvorrichtung (102) nach Anspruch 1,
wobei der erste Teil (T1) an einem Grenzteil einer Spiegelanordnung einer oder mehrerer Elektroden, die auf dem Substrat bereitgestellt sind, bereitgestellt ist.

7. Festkörperbildgebungsvorrichtung (102) nach Anspruch 6,
wobei das Substrat (11) die Vielzahl von ersten Teilen (T1) an dem Grenzteil periodisch einschließt, und
wobei ein Layoutzyklus des ersten Teils (T1) derselbe ist wie ein Layoutzyklus von Pixeln (1) mit derselben Farbe in dem Substrat (11).

8. Festkörperbildgebungsvorrichtung nach Anspruch 1,
wobei der erste Teil (T1) außerhalb eines Pixelarraybereichs (2) bereitgestellt ist.

9. Festkörperbildgebungsvorrichtung (102) nach Anspruch 1,
wobei das Substrat (11) ein Silizium{111 }substrat ist, und
wobei sich der eine oder die mehreren vertikalen Gräben (12a) in einer seitlichen Richtung erstrecken, die orthogonal zu der <110> Richtung ist; oder
wobei der eine oder die mehreren vertikalen Gräben (12a) sowohl einen Graben (12a), der sich von einer vorderen Oberfläche des Substrats in einer Längsrichtung erstreckt, als auch einen Graben (12a) einschließen, der sich von einer hinteren Oberfläche des Substrats in der Längsrichtung erstreckt.

10. Festkörperbildgebungsvorrichtung (102), umfassend:
ein Substrat (11), das einen oder mehrere vertikale Gräben (12a), die sich in einer Längsrichtung erstrecken, und einen horizontalen Graben (12b) einschließt, der sich in einer seitlichen Richtung erstreckt und mit dem einen oder den mehreren vertikalen Gräben (12a) verbunden ist,
wobei der horizontale Graben (12b) zwischen einer photoelektrischen Umwandlungseinheit (PD) und einer Ladungshalteeinheit (MEM) in dem Substrat (11) bereitgestellt ist und einen lichtblockierenden Film (14) einschließt, und
wobei der eine oder die mehreren vertikalen Gräben (12a) einschließen
einen vierten Graben (12a), der einen ersten Bereich (C1), in dem ein Stopfen (44) auf dem lichtblockierenden Film (14) in dem ersten Bereich (C1) bereitgestellt ist, der ein erster Bereich (C1) ist, der den lichtblockierenden Film (14) einschließt, und einen zweiten Bereich (C2) einschließt, in dem kein Stopfen (44) auf dem lichtblockierenden Film (14) in dem zweiten Bereich (C2) bereitgestellt ist, der ein zweiter Bereich (C2) ist, der den lichtblockierenden Film (14) einschließt, und
Festkörperbildgebungsvorrichtung (102), ferner umfassend
eine Verdrahtung (45), die über dem lichtblockierenden Film (14) in dem zweiten Bereich (C2) bereitgestellt ist und von dem Stopfen (44) auf dem lichtblockierenden Film (14) in dem ersten Bereich (C1) elektrisch isoliert ist.

11. Festkörperbildgebungsvorrichtung (102) nach Anspruch 10,
wobei jeder des ersten Bereichs (C1) und des zweiten Bereichs (C2) einen Elementtrennungsisolierfilm (13) und den lichtblockierenden Film (14) einschließt.

12. Festkörperbildgebungsvorrichtung (102) nach Anspruch 10,
wobei der erste Bereich (C1) und der zweite Bereich (C2) die gleiche Breite (L1) aufweisen; oder
wobei das Substrat ein Silizium{111}substrat ist, und
wobei sich der eine oder die mehreren vertikalen Gräben (12a) in einer seitlichen Richtung erstrecken, die orthogonal zu der <110> Richtung ist.

13. Festkörperbildgebungsvorrichtung (102), umfassend:
ein Substrat (11), das einen oder mehrere vertikale Gräben (12a), die sich in einer Längsrichtung erstrecken, und einen horizontalen Graben (12b) einschließt, der sich in einer seitlichen Richtung erstreckt und mit dem einen oder den mehreren vertikalen Gräben (12a) verbunden ist,
wobei der horizontale Graben (12b) zwischen einer photoelektrischen Umwandlungseinheit (PD) und einer Ladungshalteeinheit (MEM) in dem Substrat (11) bereitgestellt ist und einen lichtblockierenden Film (14) einschließt,
wobei der eine oder die mehreren vertikalen Gräben (12a) einen ersten Graben (12a), der eine erste Breite (L1) aufweist, einschließen und den lichtblockierenden Film (12a) einschließt, und
wobei die Dicke (L3) zwischen einer oberen Oberfläche und einer unteren Oberfläche des lichtblockierenden Films (14) in dem horizontalen Graben (12b) gleich oder größer als die erste Breite (L1) des ersten Grabens (12a) ist, wobei der eine oder die mehreren vertikalen Gräben (12a) sowohl einen Graben (12a), der sich von einer vorderen Oberfläche des Substrats (11) in einer Längsrichtung erstreckt, als auch einen Graben (12a) einschließen, der sich von einer hinteren Oberfläche des Substrats (11) in der Längsrichtung erstreckt, und
wobei der eine oder die mehreren vertikalen Gräben (12a) ferner einen zweiten Graben (12a) einschließen, der eine zweite Breite (L2) aufweist, die schmaler als die erste Breite (L1) ist, und den lichtblockierenden Film (14) nicht einschließt, und
wobei jeder des Grabens (12a), der sich von einer vorderen Oberfläche des Substrats (11) in einer Längsrichtung erstreckt, und des Grabens (12a), der sich von einer hinteren Oberfläche des Substrats (11) in der Längsrichtung erstreckt, entweder der erste Graben (12a) oder der zweite Graben (12a) ist.

14. Festkörperbildgebungsvorrichtung (102) nach Anspruch 13,
wobei der horizontale Graben (12b) den lichtblockierenden Film (14) und einen Hohlraum (43), der zwischen den lichtblockierenden Filmen (14) bereitgestellt ist, einschließt.

15. Verfahren zum Herstellen einer Festkörperbildgebungsvorrichtung (102) nach Anspruch 1, umfassend:
Ausbilden eines oder mehrerer vertikaler Gräben (12a), die sich in einer Längsrichtung in einem Substrat (11) erstrecken;
Ausbilden eines horizontalen Grabens (12b), der sich in einer seitlichen Richtung in dem Substrat (11) erstreckt und mit dem einen oder den mehreren vertikalen Gräben (12a) verbunden ist; und
Ausbilden eines lichtblockierenden Films (14) in dem horizontalen Graben (12a),
wobei der eine oder die mehreren vertikalen Gräben (12a) ausgebildet sind, um einzuschließen
einen ersten Graben (12a), der eine erste Breite (L1) aufweist und den lichtblockierenden Film (14) einschließt, und
einen zweiten Graben (12a), der eine zweite Breite (L2) aufweist, die schmaler als die erste Breite (L1) ist und den lichtblockierenden Film (14) nicht einschließt, oder
einen dritten Graben (12a), der einen ersten Teil (T1), der eine dritte Breite (W1) aufweist und den lichtblockierenden Film (14) einschließt, und einen zweiten Teil (T2) einschließt, der eine vierte Breite (W2) aufweist, die schmaler als die dritte Breite (W1) ist und den lichtblockierenden Film (14) nicht einschließt.

## Revendications

1. Dispositif d'imagerie à semi-conducteurs (102) comprenant :
un substrat (11) comportant une ou plusieurs tranchées verticales (12a) s'étendant dans une direction longitudinale et une tranchée horizontale (12b) s'étendant dans une direction latérale et reliée à la ou les tranchées verticales (12a),
dans lequel la tranchée horizontale (12b) est prévue entre une unité de conversion photoélectrique (PD) et une unité de maintien de charge (MEM) dans le substrat (11) et comporte un film bloquant la lumière (14), et
dans lequel la ou les tranchées verticales (12a) comportent
une première tranchée (12a) ayant une première largeur (L1) et comportant le film bloquant la lumière (14), et
une deuxième tranchée (12a) ayant une deuxième largeur (L2) plus étroite que la première largeur (L1) et ne comportant pas le film bloquant la lumière (14), ou
une troisième tranchée (12a) comportant une première partie (T1) ayant une troisième largeur (W1) et comportant le film de protection contre la lumière (14) et une seconde partie (T2) ayant une quatrième largeur (W2) plus étroite que la troisième largeur (W1) et ne comportant pas le film bloquant la lumière (14).

2. Dispositif d'imagerie à semi-conducteurs (102) selon la revendication 1,
dans lequel la première tranchée (12a) comporte un film isolant de séparation des éléments (13, 17) et le film bloquant la lumière (14), et
dans lequel la deuxième tranchée (12a) comporte le film isolant de séparation des éléments (13) et ne comporte pas le film bloquant la lumière (14).

3. Dispositif d'imagerie à semi-conducteurs (102) selon la revendication 1,
dans lequel le film bloquant la lumière (14) est placé entre des films de charge fixes (42) dans la tranchée horizontale (12b).

4. Dispositif d'imagerie à semi-conducteurs (102) selon la revendication 1,
dans lequel la tranchée horizontale (12b) comporte le film bloquant la lumière (14) et une cavité (43) située entre les films bloquant la lumière (14) ; ou
dans lequel l'épaisseur (L3) entre une surface supérieure et une surface inférieure du film bloquant la lumière (14) dans la tranchée horizontale (12b) est égale ou supérieure à la première largeur (L1) de la première tranchée (12a).

5. Dispositif d'imagerie à semi-conducteurs (102) selon la revendication 1, comprenant en outre une ou plusieurs électrodes (15) prévues sur le substrat et se chevauchant sur la deuxième tranchée ; ou
dans lequel la première partie (T1) comporte un film isolant de séparation des éléments (13, 17) et le film bloquant la lumière (14), et
dans lequel la seconde partie (T2) comporte le film isolant de séparation des éléments (13, 17) et ne comporte pas le film bloquant la lumière (14).

6. Dispositif d'imagerie à semi-conducteurs (102) selon la revendication 1,
dans lequel la première partie (T1) est prévue sur une partie limite d'une disposition en miroir d'une ou de plusieurs électrodes placées sur le substrat.

7. Dispositif d'imagerie à semi-conducteurs (102) selon la revendication 6,
dans lequel le substrat (11) comporte périodiquement la pluralité de premières parties (T1) au niveau de la partie limite, et
dans lequel un cycle de disposition de la première partie (T1) est identique à un cycle de disposition des pixels (1) de la même couleur dans le substrat (11).

8. Dispositif d'imagerie à semi-conducteurs selon la revendication 1,
dans lequel la première partie (T1) est située à l'extérieur d'une région de matrice de pixels (2).

9. Dispositif d'imagerie à semi-conducteurs (102) selon la revendication 1,
dans lequel le substrat (11) est un substrat de silicium {111}, et
dans lequel la ou les tranchées verticales (12a) s'étendent dans une direction latérale orthogonale à la direction <110> ; ou
dans lequel la ou les tranchées verticales (12a) comportent à la fois une tranchée (12a) s'étendant à partir d'une surface avant du substrat dans une direction longitudinale et une tranchée (12a) s'étendant à partir d'une surface arrière du substrat dans la direction longitudinale.

10. Dispositif d'imagerie à semi-conducteurs (102) comprenant :
un substrat (11) comportant une ou plusieurs tranchées verticales (12a) s'étendant dans une direction longitudinale et une tranchée horizontale (12b) s'étendant dans une direction latérale et reliée à la ou les tranchées verticales (12a),
dans lequel la tranchée horizontale (12b) est prévue entre une unité de conversion photoélectrique (PD) et une unité de maintien de charge (MEM) dans le substrat (11) et comporte un film bloquant la lumière (14), et
dans lequel la ou les tranchées verticales (12a) comportent
une quatrième tranchée (12a) comportant une première région (C1) dans laquelle un bouchon (44) est prévu sur le film bloquant la lumière (14) dans la première région (C1), qui est une première région (C1) comportant le film bloquant la lumière (14), et une seconde région (C2) dans laquelle aucun bouchon (44) n'est placé sur le film bloquant la lumière (14) dans la seconde région (C2), qui est une seconde région (C2) comprenant le film bloquant la lumière (14), et
le dispositif d'imagerie à semi-conducteurs (102) comprenant en outre
un câblage (45) prévu au-dessus du film bloquant la lumière (14) dans la seconde région (C2) et isolé électriquement de la fiche (44) située sur le film bloquant la lumière (14) dans la première région (C1).

11. Dispositif d'imagerie à semi-conducteurs (102) selon la revendication 10,
dans lequel la première région (C1) et la seconde région (C2) comportent chacune un film isolant de séparation des éléments (13) et un film bloquant la lumière (14).

12. Dispositif d'imagerie à semi-conducteurs (102) selon la revendication 10,
dans lequel la première région (C1) et la seconde région (C2) ont la même largeur (L1) ; ou
dans lequel le substrat est un substrat de silicium {111}, et
dans lequel la ou les tranchées verticales (12a) s'étendent dans une direction latérale orthogonale à la direction <110>.

13. Dispositif d'imagerie à semi-conducteurs (102) comprenant :
un substrat (11) comportant une ou plusieurs tranchées verticales (12a) s'étendant dans une direction longitudinale et une tranchée horizontale (12b) s'étendant dans une direction latérale et reliée à la ou les tranchées verticales (12a),
dans lequel la tranchée horizontale (12b) est prévue entre une unité de conversion photoélectrique (PD) et une unité de maintien de charge (MEM) dans le substrat (11) et comporte un film bloquant la lumière (14),
dans lequel la ou les tranchées verticales (12a) comportent une première tranchée (12a) ayant une première largeur (L1) et comportant le film bloquant la lumière (12a), et
dans lequel l'épaisseur (L3) entre une surface supérieure et une surface inférieure du film bloquant la lumière (14) dans la tranchée horizontale (12b) est égale ou supérieure à la première largeur (L1) de la première tranchée (12a), dans lequel la ou les tranchées verticales (12a) comportent à la fois une tranchée (12a) s'étendant à partir d'une surface avant du substrat (11) dans une direction longitudinale et une tranchée (12a) s'étendant à partir d'une surface arrière du substrat (11) dans la direction longitudinale, et
dans lequel la ou les tranchées verticales (12a) comportent en outre une deuxième tranchée (12a) ayant une deuxième largeur (L2) plus étroite que la première largeur (L1) et ne comprenant pas le film bloquant la lumière (14), et
dans lequel chacune des tranchées (12a) s'étendant à partir d'une surface avant du substrat (11) dans une direction longitudinale et la tranchée (12a) s'étendant à partir d'une surface arrière du substrat (11) dans la direction longitudinale est soit la première tranchée (12a), soit la deuxième tranchée (12a).

14. Dispositif d'imagerie à semi-conducteurs (102) selon la revendication 13,
dans lequel la tranchée horizontale (12b) comprend le film bloquant la lumière (14) et une cavité (43) prévue entre les films bloquant la lumière (14).

15. Procédé de fabrication d'un dispositif d'imagerie à semi-conducteurs (102) tel que décrit dans la revendication 1, comprenant :
la formation d'une ou plusieurs tranchées verticales (12a) s'étendant dans une direction longitudinale dans un substrat (11) ;
la formation d'une tranchée horizontale (12b) qui s'étend latéralement dans le substrat (11) et qui est reliée à une ou plusieurs tranchées verticales (12a) ; et
la formation d'un film bloquant la lumière (14) dans la tranchée horizontale (12a),
dans lequel la ou les tranchées verticales (12a) sont formées pour comporter
une première tranchée (12a) ayant une première largeur (L1) et comportant le film bloquant la lumière (14), et
une deuxième tranchée (12a) ayant une deuxième largeur (L2) plus étroite que la première largeur (L1) et ne comportant pas le film bloquant la lumière (14), ou
une troisième tranchée (12a) comportant une première partie (T1) ayant une troisième largeur (W1) et comportant le film bloquant la lumière (14) et une seconde partie (T2) ayant une quatrième largeur (W2) plus étroite que la troisième largeur (W1) et ne comportant pas le film bloquant la lumière (14).
